# EUROPEAN PATENT APPLICATION

(11) **EP 4 665 090 A2**
(43) Date of publication of application: **17.12.2025**
(21) Application number: 25213097.6
(22) Date of filing: 12.07.2023
(51) Int. Cl.: H05K 1/02

(54) **ELECTRONIC APPARATUS COMPRISING FLEXIBLE PRINTED CIRCUIT BOARD**

(30) Priority: 22.07.2022 KR 20220091117; 09.08.2022 KR 20220099302
(62) Divisional of application: 23772738.3
(71) Applicant: Samsung Electronics Co., Ltd., Suwon-si, Gyeonggi-do 16677 (KR)
(72) Inventor: KWON, Kihwan, 16677 Suwon-si (KR); WOO, Jaehoon, 16677 Suwon-si (KR); JUNG, Youngjin, 16677 Suwon-si (KR); CHUN, Woosung, 16677 Suwon-si (KR)
(74) Representative: HGF

(57) **Abstract**

An electronic device including a flexible printed circuit board (FPCB) is provided. The electronic device includes a display including a first area and a second area, a first housing supporting the first area, a second housing supporting the second area, a hinge structure foldably connecting the first housing to the second housing based on a folding axis and adjusting a folding angle formed by the first housing and the second housing relative to the folding axis, and an FPCB extending in an extending direction.

## Description

### BACKGROUND

### 1. Field

The disclosure relates to a flexible printed circuit board., FPCB, and an electronic device comprising a flexible printed circuit board, FPCB.

### 2. Description of Related Art

In recent years, electronic devices have progressed from devices having uniform rectangular shapes to devices having shapes of various designs and functions to satisfy purchasing desires of consumers. For example, such electronic devices may include foldable electronic devices that may be transformed in size according to use states (e.g. may be transformed from a folded state to an unfolded state). In such foldable electronic devices, a flexible printed circuit board (FPCB), which may flexibly change its shape, may be used to electrically connect various components within the device.

### SUMMARY

According to one embodiment, an electronic device includes a display including a first area and a second area, a first housing supporting the first area, a second housing supporting the second area, a hinge structure foldably connecting the first housing to the second housing based on a folding axis and adjusting a folding angle formed by the first housing and the second housing relative to the folding axis, and a flexible printed circuit board (FPCB) extending in an extending direction. In one embodiment, the FPCB includes a driving area traversing the folding axis and at least partially bending in response to a change in the folding angle, a first fixed area extending from the driving area to a first space formed by the first housing, and a second fixed area extending from the driving area to a second space formed by the second housing. In one embodiment, the FPCB includes a first base layer including a first base surface and a second base surface opposite to the first base surface, a first metal layer arranged on the second base surface and forming a plurality of signal lines extending in the extending direction, and a first cover layer arranged to cover the first metal layer in a direction of the second base surface. In one embodiment, a thickness of the first cover layer in the driving area is different from a thickness of the first cover layer in the first fixed area or the second fixed area.

According to one embodiment, an FPCB arranged in an electronic device includes a first base layer including a first base surface and a second base surface opposite to the first base surface, a first metal layer arranged on the second base surface and forming a plurality of signal lines arranged in an extending direction, a first cover layer arranged to cover the first metal layer in a direction of the second base surface, a second base layer arranged in a direction of the first base surface, a second metal layer arranged on the second base layer to be opposite to the first base layer, and a second cover layer arranged on the second base layer to cover the second metal layer. In one embodiment, the FPCB includes, based on the extending direction, a driving area, a first fixed area, and a second fixed area, wherein the first fixed area and the second fixed area are arranged in opposite directions to each other relative to the driving area. In one embodiment, a thickness of the first cover layer in the driving area is different from a thickness of the first cover layer in the first fixed area or the second fixed area.

According to one embodiment, an electronic device includes a display including a first area and a second area, a first housing forming a first space on a rear surface of the first area, a second housing forming a second space on a rear surface of the second area, a hinge structure including a hinge housing connecting the first housing to the second housing based on the folding axis and adjusting a folding angle formed by the first housing and the second housing, and an FPCB traversing the folding axis and extending from the first space to the second space in the extending direction. In one embodiment, the FPCB includes a driving area at least partially arranged in the hinge housing and at least partially bending in response to a change in the folding angle, a first fixed area extending from the driving area to the first space, a second fixed area extending from the driving area to the second space. In one embodiment, the FPCB includes a first base layer including a first base surface and a second base surface opposite to the first base surface, a first metal layer arranged on the second base surface and forming a plurality of signal lines arranged in an extending direction, a first cover layer arranged to cover the first metal layer in a direction of the second base surface, a second base layer arranged in a direction of the first base surface, a second metal layer arranged on the second base layer to be opposite to the first base layer, and a second cover layer arranged on the second base layer to cover the second metal layer. In one embodiment, a thickness of the first cover layer in the driving area is greater than a thickness of the first cover layer in the first fixed area or the second fixed area. In one embodiment, an interval between the plurality of signal lines in the driving area is greater than an interval between the plurality of signal lines in the first fixed area or an interval between the plurality of signal lines in the second fixed area.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram of an electronic device in a network environment according to one embodiment;
FIG. 2A is a view of an electronic device in a first state according to one embodiment;
FIG. 2B is a view of an electronic device in a second state according to one embodiment;
FIG. 2C is an exploded perspective view of an electronic device according to one embodiment;
FIG. 3A is a view of an electronic device in a first state with omission of a display to arrange a flexible printed circuit board (FPCB) according to one embodiment;
FIG. 3B is a cross-sectional view of an FPCB of an electronic device in a first state according to one embodiment;
FIG. 3C is a cross-sectional view of an FPCB of an electronic device in a second state according to one embodiment;
FIG. 4A is a perspective view of an FPCB according to one embodiment;
FIG. 4B is a cross-sectional view of an FPCB taken along the line A-A of FIG. 4A.
FIG. 5A is a cross-sectional view of an FPCB according to one embodiment;
FIG. 5B is a view of an example of a plurality of signal lines according to one embodiment;
FIG. 6A is a cross-sectional view of an FPCB according to one embodiment; and
FIG. 6B is a view of an example of a plurality of signal lines according to one embodiment.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

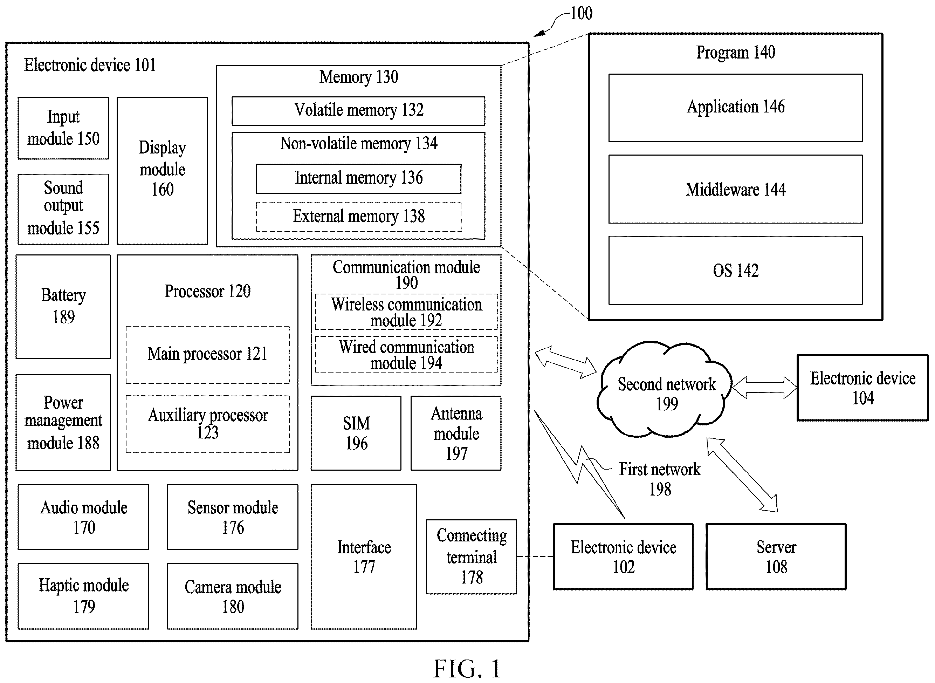

FIG. 1 is a block diagram illustrating an electronic device in a network environment according to one embodiment. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to one embodiment, the electronic device 101 may communicate with the electronic device 104 via the server 108. According to one embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to one embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to one embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to one embodiment, the auxiliary processor 123 (e.g., an ISP or a CP) may be implemented as a portion of another component (e.g., the camera module 180 or the communication module 190) that is functionally related to the auxiliary processor 123. According to one embodiment, the auxiliary processor 123 (e.g., an NPU) may include a hardware structure specified for artificial intelligence (AI) model processing. An AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to one embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to one embodiment, the display device 160 may include a touch sensor adapted to sense a touch, or a pressure sensor adapted to measure an intensity of a force incurred by the touch.

The audio module 170 may convert a sound into an electric signal or vice versa. According to one embodiment, the audio module 170 may obtain the sound via the input device 150 or output the sound via the sound output device 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to one embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to one embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to one embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to one embodiment, the haptic module 179 may include, for example, a motor, a piezoelectric element, or an electric stimulator.

The camera module 180 may capture a still image and moving images. According to one embodiment, the camera module 180 may include one or more lenses, image sensors, ISPs, or flashes.

The power management module 188 may manage power supplied to the electronic device 101. According to one embodiment, the power management module 188 may be implemented as, for example, at least a part of a power management integrated circuit (PMIC).

The battery 189 may supply power to at least one component of the electronic device 101. According to one embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an example embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to one embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to one embodiment, the antenna module 197 may include an antenna including a radiating element including a conductive material or a conductive pattern formed in or on a substrate (e.g., a printed circuit board (PCB)). According to one embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to one embodiment, another component (e.g., a radio frequency integrated circuit (RFIC)) other than the radiating element may be additionally formed as a part of the antenna module 197.

According to one embodiment, the antenna module 197 may form a mmWave antenna module. According to an example embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an example embodiment, commands or data may be transmitted or received between the electronic device 101 and the external electronic device 104 via the server 108 coupled with the second network 199. Each of the external electronic devices 102 or 104 may be a device of the same type as or a different type from the electronic device 101. According to one embodiment, all or some of operations to be executed by the electronic device 101 may be executed at one or more of the external electronic devices 102, 104, and 108. For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or mobile edge computing. In one embodiment, the external electronic device 104 may include an Internet-of-things (IoT) device. The server 108 may be an intelligent server using machine learning and/or a neural network. According to an example embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic device may include, for example, a portable communication device (e.g., a smartphone), a computer device, a portable multimedia device, a portable medical device, a camera, a wearable device, or a home appliance device. According to an example embodiment of the disclosure, the electronic device is not limited to those described above.

It should be appreciated that various example embodiments of the present disclosure and the terms used therein are not intended to limit the technological features set forth herein to particular example embodiments and include various changes, equivalents, or replacements for a corresponding example embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to one embodiment, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to one embodiment, a method according to one embodiment of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

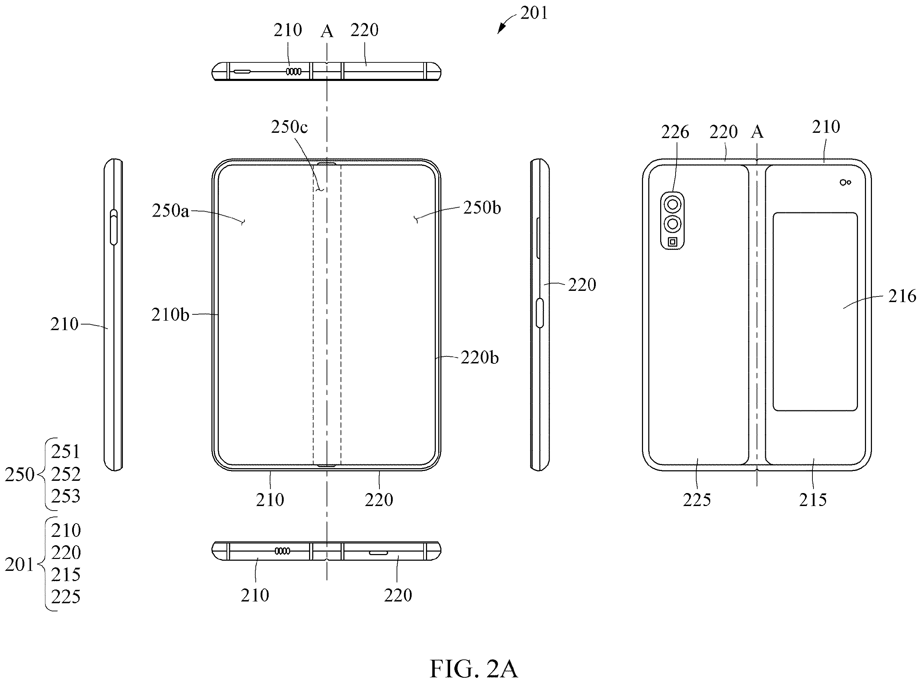

In FIG. 2A and other following drawings, illustrated is a spatial coordinate system defined by an X-axis, a Y-axis, and a Z-axis that are orthogonal to each other. The X-axis may represent a width direction of an electronic device, the Y-axis may represent a length direction of the electronic device, and the Z-axis may represent a height (or thickness) direction of the electronic device.

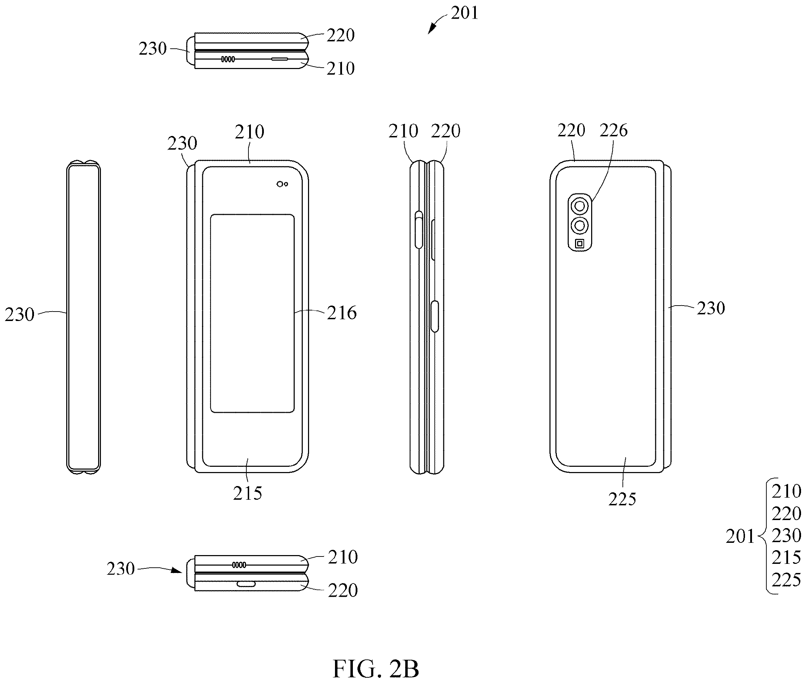

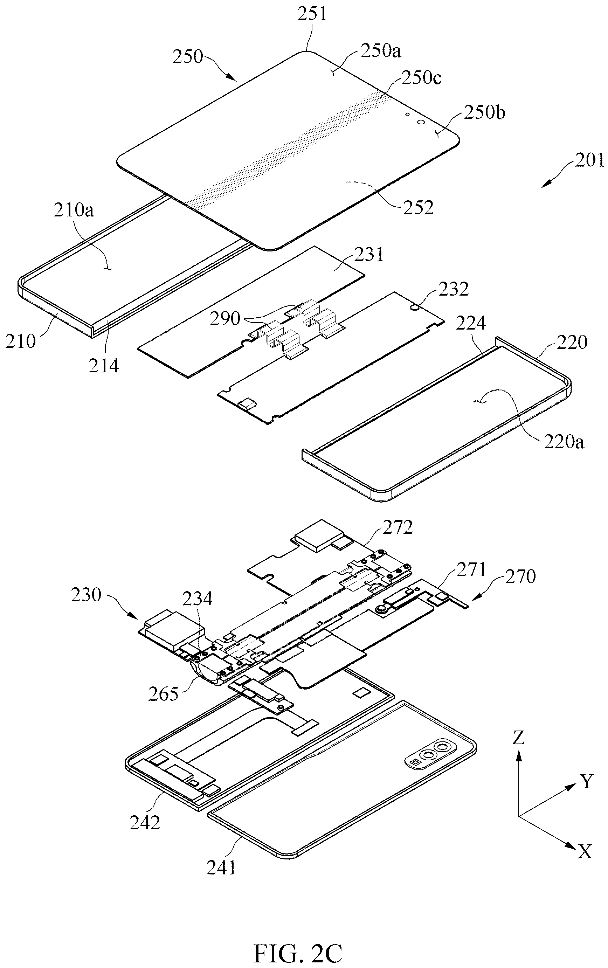

FIG. 2A is a view of an electronic device in a first state (e.g. an unfolded, or open, state) according to one embodiment, FIG. 2B is a view of an electronic device in a second state (e.g. a folded, or closed, state) according to one embodiment, and FIG. 2C is an exploded perspective view of an electronic device according to one embodiment.

Referring to FIGS. 2A to 2C, in one embodiment, an electronic device 201 (e.g., the electronic device 101 of FIG. 1) may include a pair of housings 210 and 220 and a display 250 (e.g., the display module 160 of FIG. 1) arranged in a space formed by the pair of housings 210 and 220. In one embodiment, a surface (or a surface on which the display 250 is visually visible from the outside), in which the display 250 is arranged, of the electronic device 201 may be defined as the front surface of the electronic device 201 and a surface opposite to the front surface thereof may be defined as the rear surface of the electronic device 201. A surface surrounding a space between the front surface and the rear surface may be defined as a side surface of the electronic device 201.

In one embodiment, an electronic device (e.g., the electronic device 101 of FIG. 1) may include a first housing 210, a second housing 220, a first rear cover 215, a second rear cover 225, a hinge structure 230, a display 250, PCBs 270, and a flexible PCB (FPCB) 290. In one embodiment, the electronic device 201 may not be limited to the shape and combination relationship illustrated in FIGS. 2A and 2B, and may have a component combination relationship in a different structure.

In one embodiment, the first housing 210 and the second housing 220 may be arranged on both sides of a folding axis A and may be substantially symmetrical to the folding axis A. In one embodiment, an angle or a distance mutually formed by the first housing 210 and the second housing 220 may vary depending on a state of the electronic device 201. For example, depending on whether the electronic device 201 is in a first state (e.g., an unfolded state) as illustrated in FIG. 2A, a second state (e.g., a folded state) as illustrated in FIG. 2B, or an intermediate state between the first state and the second state, a distance or an angle mutually formed by (or between) the first housing 210 and the second housing 220 may vary.

In one embodiment, the first housing 210 may include a first surface facing the front surface of the electronic device 201, a second surface opposite to the first surface, and a first side portion enclosing at least a portion of a space between the first surface and the second surface. The second housing 220 may include a third surface facing the front surface of the electronic device 201, a fourth surface opposite to the third surface, and a second side portion enclosing at least a portion of a space between the third surface and the fourth surface. The first surface and the third surface may face each other when the electronic device 201 is in the folded state as illustrated in FIG. 2B.

In one embodiment, the first housing 210 and the second housing 220 may form a recess of which a front surface is open to accommodate the display 250. In one embodiment, at least a portion of the first housing 210 and the second housing 220 may be formed of a metal material or a non-metal material having appropriate rigidness to support the display 250. In one embodiment, at least a portion of the first housing 210 and the second housing 220 formed of a metal material may provide a ground plane of the electronic device 201 and may be electrically connected to a ground line formed on the PCB 270 arranged inside the electronic device 201.

In one embodiment, the electronic device 201 may include at least one component to perform various functions, wherein the component is exposed at the front surface of the electronic device 201 through at least one opening formed in the front surface of the foldable electronic device 201. For example, the component may include at least one of a front camera module, a receiver, a proximity sensor, an illuminance sensor, an iris recognition sensor, an ultrasonic sensor, or an indicator.

In one embodiment, the first rear cover 215 and the second rear cover 225 may be arranged on the rear surface of the electronic device 201. For example, the first rear cover 215 may be arranged on the second surface of the first housing 210 and the second rear cover 225 may be arranged on the fourth surface of the second housing 220. At least a portion of an edge of the first rear cover 215 may be enclosed by the first housing 210 and at least a portion of an edge of the second rear cover 225 may be enclosed by the second housing 220.

In one embodiment, the first rear cover 215 and the second rear cover 225 may have substantially symmetrical shapes based on the folding axis A. In one embodiment, the first rear cover 215 and the second rear cover 225 may have different shapes. In one embodiment, the first housing 210 and the first rear cover 215 may be integrally formed as one and the second housing 220 and the second rear cover 225 may be integrally formed as one.

In an example embodiment, the first housing 210, the second housing 220, the first rear cover 215, and the second rear cover 225 may provide a space in which various components (e.g., a PCB, the antenna module 197 of FIG. 1, the sensor module 176 of FIG. 1, or the battery 189 of FIG. 1) of the electronic device 201 may be arranged through a structure in which the first housing 210, the second housing 220, the first rear cover 215, and the second rear cover 225 are coupled to one another. In an example embodiment, at least one component may be visually exposed on the rear surface of the electronic device 201. For example, at least a portion of a sub-display may be visually exposed through a first rear area 216 of the first rear cover 215. In one embodiment, at least one component may be visually exposed through a second rear area 226 of the second rear cover 225. In this case, the component may include a proximity sensor, a rear camera module, and/or a flash.

In one embodiment, the display 250 may be arranged in a space formed by a foldable housing 201. For example, the display 250 may be arranged in a recess formed by the pair of housings 210 and 220. The display 250 may be arranged to constitute most of the front surface of the electronic device 201. The front surface of the electronic device 201 may include an area accommodating the display 250, a partial area (e.g., an edge area) of the first housing 210 adjacent to the display 250, and a partial area (e.g., an edge area) of the second housing 220. The rear surface of the electronic device 201 may include the first rear cover 215, a partial area (e.g., an edge area) of the first housing 210 adjacent to the first rear cover 215, the second rear cover 225, and a partial area (e.g., an edge area) of the second housing 220 adjacent to the second rear cover 225. In one embodiment, at least a partial area of the display 250 may be deformed into a planar or curved surface.

In one embodiment, at least a partial area of the display 250 may be deformed. In one embodiment, the display 250 may include a folding area 250c arranged along the folding axis A, a first area 250a arranged on a first side (e.g., the left side of the folding area 250c of FIG. 2A) based on the folding area 250c, and a second area 250b arranged on a second side (e.g., the right side of the folding area 250c of FIG. 2A) based on the folding area 250c. In one embodiment, the first area 250a may be supported by the first housing 210 and the second housing 250b may be supported by the second housing 220. However, the illustrated area division of the display 250 is an example, and the display 250 may be divided into a plurality of areas depending on the structure or functions of the display 250. For example, as illustrated in FIG. 2A, the display 250 may be divided into areas based on the folding area 203 extending in parallel to the folding axis A. In another example, the display 250 may be divided into areas based on another folding axis (e.g., a folding axis parallel with a width direction of an electronic device).

According to one embodiment, the display 250 may be coupled to or disposed adjacent to a touch panel in which a touch sensing circuit and a pressure sensor configured to measure an intensity (or pressure) of a touch are provided. For example, the display 250 may be coupled to or disposed adjacent to a touch panel for detecting a stylus pen of an electromagnetic resonance (EMR) type, as an example of the touch panel.

According to one embodiment, the first area 250a and the second area 250b may generally have symmetrical shapes with respect to the folding area 250c. In one embodiment, a notch that is at least a partial cut to expose a sensor may be formed in at least one of the first area 250a and the second area 250b. For example, the first area 250a and the second area 250b may include portions having mutually symmetrical shapes and portions having mutually asymmetrical shapes.

In one embodiment, the hinge structure 230 may be arranged between the first housing 210 and the second housing 220 and may include a hinge cover 265 to cover a space between the first housing 210 and the second housing 220. In one embodiment, the hinge cover 265 may be visually exposed to the outside or occluded by the first housing 210 and the second housing 220, based on an operational state of the electronic device 201 For example, when the electronic device 201 is in the first state as illustrated in FIG. 2A, the hinge cover 265 may be occluded by the first housing 210 and the second housing 220 and not be exposed to the outside, and when the electronic device 201 is in the second state as illustrated in FIG. 2B, the hinge cover 265 may be visually exposed to the outside between the first housing 210 and the second housing 220.

When the electronic device 201 is in the intermediate state forming an angle between the first state of FIG. 2A and the second state of FIG. 2B, at least a portion of the hinge cover 265 may be exposed to the outside between the first housing 210 and the second housing 220 and in this case, an area of the hinge cover 265 exposed to the outside may be less than an exposed area of the hinge cover 265 in the second state (e.g., a folded state) of the electronic device 201. In one embodiment, the hinge cover 265 may include a curved shape.

In one embodiment, when the electronic device 201 is in the first state (e.g., an unfolded state of FIG. 2A), the first housing 210 and the second housing 220 may form a first angle (e.g., about 180 degrees) with each other and the first area 250a and the second area 250b of the display 250 may be oriented in substantially the same direction and may form substantially the same plane. In this case, the folding area 250c of the display 250 may be on substantially the same plane as the first area 250a and the second area 250b. In one embodiment, when the electronic device 201 is in the unfolded state, as the first housing 210 rotates at a second angle (e.g., about 360 degrees) relative to the second housing 220, the second surface and the fourth surface may be reversely folded to face each other.

In one embodiment, when the electronic device 201 is in the second state (e.g., the folded state of FIG. 2B), the first housing 210 and the second housing 220 may face each other. In this case, the first area 250a and the second area 250b of the display 250 may form a narrow angle (e.g., 0 to 10 degrees) therebetween and may face each other. In this case, at least a portion of the folding area 250c of the display 250 may be deformed into a curved surface.

In one embodiment, when the electronic device 201 is in an intermediate state between the first state and the second state (e.g., an intermediate open state), the first housing 210 and the second housing 220 may be arranged to form a predetermined angle. The surface of the first area 250a and the surface of the second area 250b of the display 250 may form an angle greater than that in the second state (e.g., a folded state) and less than that in the first state (e.g., a fully open state). At least a portion of the folding area 250c may include a curved surface and in this case, the curvature may be less than that in the second state (e.g., the folded state).

In one embodiment, the display 250 may include a display panel 251 (e.g., a flexible display panel) and at least one plate 252 or a layer arranged on the rear surface of the display panel 251.

In one embodiment, the display panel 251 may include a flexible display substrate, a plurality of display elements coupled to the display substrate to form pixels, one or more conductive lines coupled to the display substrate and electrically connected to other display elements, and a thin-film encapsulation layer configured to prevent inflow of external oxygen and moisture. The display panel 251 may include a touch panel, or the display panel 251 and the touch panel may be integrally formed therewith.

The display substrate may be formed of a flexible material, for example, a plastic material, such as polyimide (PI), but the material of the display substrate is not limited thereto and may include other flexible materials. The plurality of display elements may be arranged on the display substrate and form some pixels. For example, the plurality of display elements may be arranged in a matrix form on the display substrate to form pixels of the display panel 251. In this case, the plurality of display elements may include a fluorescent material or an organic fluorescent material that may express colors. For example, the display elements may include organic light-emitting diodes (OLEDs). The conductive lines may include one or more gate signal lines or one or more data signal lines. For example, the conductive lines may include a plurality of gate signal lines and a plurality of data signal lines, and the plurality of gate signal lines and the plurality of data signal lines may be arranged in a matrix form. In this case, the plurality of display elements may be arranged adjacent to a point where a plurality of lines intersect, and may be electrically connected to each line. The thin film encapsulation layer may cover the display substrate, the plurality of display elements, and the conductive lines, thereby preventing inflow of oxygen and moisture from an outside. In one embodiment, the thin film encapsulation layer may be formed by alternately stacking one or more organic film layers and one or more inorganic film layers.

In one embodiment, the touch panel may be formed as an integral body with the display panel 251 or attached thereto. For example, the touch panel may be formed by patterning an aluminum metal mesh sensor on the thin film encapsulation layer of the display panel 251.

In one embodiment, the polarizing film may be stacked between the display panel 251 and the touch panel. The polarizing film may improve visibility of the display 250. The polarizing film may change a phase of light passing through the display 250. For example, the polarizing film may convert linearly polarized light into circularly polarized light or convert circularly polarized light into linearly polarized light, thereby preventing reflection of light incident to the display panel 251.

The window layer may be formed of a transparent plastic film having high flexibility and high hardness. For example, the window layer may be formed of a PI or polyethylene terephthalate (PET) film. In one embodiment, the window layer may be formed as multiple layers including a plurality of plastic films.

In one embodiment, the plate 252 may support the rear surface of the display panel 251, thereby improving the impact resistance of the display panel 251. In one embodiment, the plate 252 may be divided into areas to support a rear surface of the first area 250a and a rear surface of the second area 250b of the display panel 251, respectively. In this case, the respective areas of the plate 252 may be separately attached to the rear surface of the first area 250a and the rear surface of the second area 250b of the display 250 so as not to contact each other along the folding axis A. According to this structure, the plate 252 may not interfere with the folding operation of the display 250 performed along the folding axis A.

In one embodiment, the plate 252 may be formed of a conductive material, for example, copper or an alloy material including copper. In this case, the plate 251 may function as a heat transfer path that transfers heat generated by an internal component (e.g., an AP) of the electronic device 201 to the display panel 251 while improving the impact resistance of the display 250.

The hinge structure 230 may include a first support plate 231, a second support plate 232, a hinge housing 234 between the first support plate 231 and the second support plate 232, and a FPCB 290 arranged to traverse the first support plate 231 and the second support plate 232. In one embodiment, the FPCB 290 may be a FPCB.

In one embodiment, the first support plate 231 may be in a rear direction of the first area 250a of the display 250 and the second support plate 232 may be in a rear direction of the second area 250b of the display 250. In one embodiment, the first support plate 231 may be connected to a first side (e.g., the -X direction of FIG. 2C) of the hinge housing 234 and the second support plate 232 may be connected to a second side (e.g., the +X direction of FIG. 2C) of the hinge housing 234. The first support plate 231 may be inserted into a first space 210a inside the first housing 210 and the second support plate 232 may be inserted into a second space 220a inside the second housing 220, and thus, the first housing 210 and the second housing 220 may be connected to the hinge structure 230.

In one embodiment, the first housing 210 may include a first rotation support surface 214, and the second housing 220 may include a second rotation support surface 224 corresponding to the first rotation support surface 214. The first rotation support surface 214 and the second rotation support surface 224 may include curved surfaces corresponding to the curved surfaces included in the hinge cover 265.

In one embodiment, when the electronic device 201 is in an unfolded state (e.g., the electronic device 201 of FIG. 2A), the first rotation support surface 214 and the second rotation support surface 224 may cover the hinge cover 265 such that the hinge cover 265 may not be exposed through the rear surface of the electronic device 201 or may be minimally exposed. Meanwhile, when the electronic device 201 is in a folded state (e.g., the electronic device 201 of FIG. 2B), the first rotation support surface 214 and the second rotation support surface 224 may rotate along the curved surfaces included in the hinge cover 265 such that the hinge cover 265 may be maximally exposed through the rear surface of the electronic device 201.

In one embodiment, the PCB 270 may include a first PCB 271 arranged on the side of the first support plate 231 and a second PCB 272 arranged on the side of the second support plate 232. The first PCB 271 and the second PCB 272 may be arranged inside a space formed by the hinge structure 230, the first housing 210, the second housing 220, the first rear cover 215, and the second rear cover 225. For example, the first PCB 271 may be arranged in the first space 210a inside the first housing 210 and the second PCB 272 may be arranged in the second space 220a inside the second housing 220. In this case, the first PCB 271 may be arranged between the first support plate 231 and the rear surface of the first housing 210 and the second PCB 272 may be arranged between the second support plate 232 and the rear surface of the second housing 220. Components for implementing various functions of the electronic device 201 may be mounted on the first PCB 271 and the second PCB 272.

In one embodiment, the FPCB 290 may connect components arranged inside the first housing 210 and the second housing 220. For example, the FPCB 290 may connect a first electronic or electrical component arranged inside the first housing 210 (e.g. within a first space), and a second electronic or electrical component arranged inside the second housing 220 (e.g. within a second space). In an example, , the FPCB 290 may connect the first FPCB 271 (e.g. arranged in a first space 210a inside the first housing 210) to the second FPCB 272 (e.g. arranged in the second space 220a inside the second housing 220). In some examples, the FPCB 290 may be connected to the hinge structure 230. At least a portion of the FPCB 290 may be arranged in a space formed by the hinge housing 234 and both ends of the FPCB 290 may extend to the first space 210a and the second space 220b by penetrating the first support plate 231 and the second support plate 232, respectively. In one embodiment, the FPCB 290 may be arranged in a direction (e.g., the X-axis direction of FIG. 2C) perpendicular to the folding axis A of the electronic device 201.

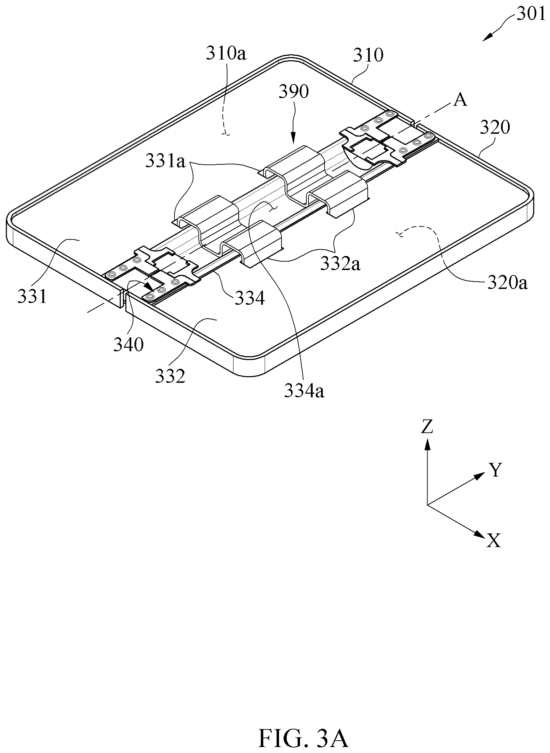

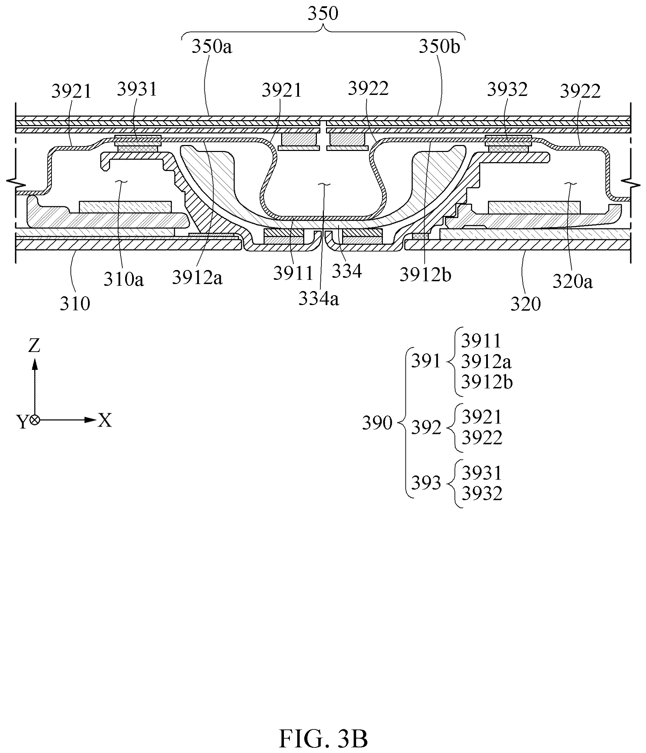

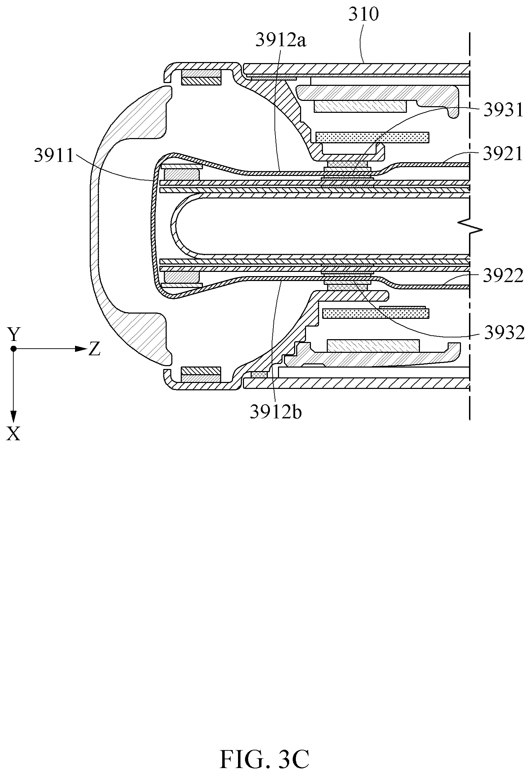

FIG. 3A is a view of an electronic device in a first state (e.g. an unfolded state) with omission of a display to arrange an FPCB according to one embodiment, FIG. 3B is a cross-sectional view of an FPCB of an electronic device in a first state according to one embodiment, and FIG. 3C is a cross-sectional view of an FPCB of an electronic device in a second state (e.g. a folded state) according to one embodiment.

Referring to FIGS. 3A to 3C, an electronic device 301 (e.g., the electronic device 101 of FIG. 1 and the electronic device 201 of FIG. 2A) in one embodiment may include a display 350, a first housing 310, a second housing 320, a hinge structure 340, and an FPCB 390.

In one embodiment, the display 350 may include a first area 350a and a second area 350b, where the display 350 may fold (or bend) based on a folding axis. That is, the display 350 may be folded, or bent, along the folding axis, such that the first area 350a and the second area 350b form an area of the display 350 on either side of the folding axis. In the first state (e.g. an unfolded state) as illustrated in FIG. 3B, the first area 350a and the second area 350b of the display 350 may form substantially the same plane. In the second state (e.g. a folded state) as illustrated in FIG. 3C, the first area 350a and the second area 350b of the display 350 may face each other.

In one embodiment, the first housing 310 and the second housing 320 may be rotatably connected to the hinge structure 340 on the folding axis. In one embodiment, the first housing 310 may form a first space 310a on the rear surface of the first area 350a and the second housing 320 may form a second space 320a on the rear surface of the second area 350b.

In one embodiment, the hinge structure 340 may rotatably connect the first housing 310 to the second housing 320. In one embodiment, the hinge structure 340 may include a hinge housing 334, a first support plate 331, and a second support plate 332. In one embodiment, a hinge space 334a may be formed in the hinge housing 334.

In one embodiment, the first support plate 331 and the second support plate 332 may be rotatably connected to the hinge housing 334 based on the folding axis. For example, the first support plate 331 may connect the first housing 310 to the hinge housing 334, and the second support plate 332 may connect the second housing 320 to the hinge housing 334. In one embodiment, at least a portion of the first support plate 331 may be arranged in the first space 310a and the at least a portion of the second support plate 332 may be arranged in the second space 320a. In one embodiment, at least one first opening 331a penetrating the surface of the first support plate 331 may be formed in the first support plate 331 and at least one second opening 332a penetrating the surface of the second support plate 332 may be formed in the second support plate 332.

In one embodiment, the FPCB 390 may electrically connect components arranged in the first space 310a and the second space 320a, for example, a first PCB (e.g., the first PCB 271 of FIG. 2C) to a second PCB (e.g., the second PCB 272 of FIG. 2C). In one embodiment, the FPCB 390 may extend from the first space 310a to the second space 320a in an extending direction (e.g., the X-axis direction, in the direction of the longitudinal length of the FPCB, along its extending length, that is the direction in which the FPCB extends in a directional perpendicular to the folding axis) while traversing (e.g. extending across) the folding axis. In one embodiment, at least a portion of the FPCB 390 may be arranged in the hinge space 334a formed by the hinge housing 334. Both ends of the FPCB 390 may extend to the first space 310a and the second space 320a through the first opening 331a and the second opening 332a, respectively.

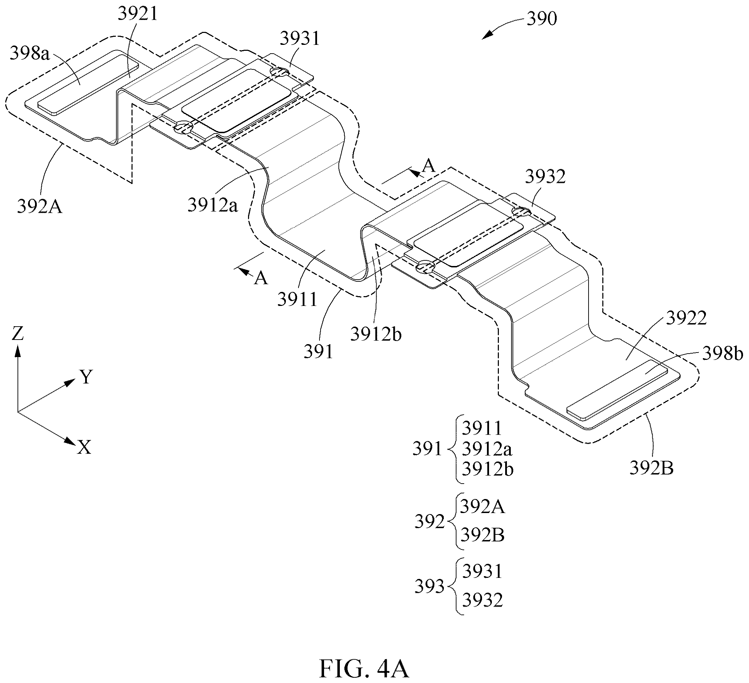

In one embodiment, based on the extending direction (e.g., the X-axis direction, a longitudinal length of the FPCB), the FPCB 390 may be divided into a plurality of areas. For example, the FPCB 390 may include a driving area (e.g., a driving area 391 of FIG. 4A), a first fixed area (e.g., a first fixed area 392A of FIG. 4A), and a second fixed area (e.g., a second fixed area 392B of FIG. 4A).

In one embodiment, at least a portion of the driving area 391 of the FPCB 390 may be arranged in the hinge housing 334 and both ends of the driving area 391 may extend to the first support plate 331 and the second support plate 332, respectively. In examples, a driving area 391 of the FPCB 390 refers to the area that may be repeatedly driven (e.g. experiences an external driving, or bending, force) at an angle when the foldable device is open (or unfolded) state and closed (or folded) state. In examples, the driving area 391 may also be referred to as a bending area, a flexible area, or a deformable area. That is, in one embodiment, at least a portion of the driving area 391 may bend in response to a change (e.g. a driven change, such as by a user) in a folding angle of the electronic device 301. In one embodiment, the driving area 391 may include a central portion 3911, a first bending portion 3912a, and a second bending portion 3912b, wherein the first bending portion 3912a and the second bending portion 3912b are respectively connected to both ends of the central portion 3911.

In one embodiment, the central portion 3911 may be arranged in the hinge space 334a. In one embodiment, the first bending portion 3912a may extend from the central portion 3911 to the first support plate 331. The second bending portion 3912b may extend from the central portion 3911 to the second support plate 332. For example, the first bending portion 3912a may extend from the hinge space 334a to the surface of the first support plate 331, and the second bending portion 3912b may extend from the hinge space 334a to the surface of the second support plate 332. In one embodiment, the first bending portion 3912a and the second bending portion 3912b may partially bend in response to a change in a folding angle of the electronic device 301. For example, in response to a change in a folding state of the electronic device 301, the first and second bending portions 3912a and 3912b may bend and the shape of the driving area 391 of the FPCB 390 may change.

In one embodiment, the first fixed area 392A may extend from the driving area 391 to the first space 310a and the second fixed area 392B may extend from the driving area 391 to the second space 320a. In one embodiment, at least a portion of the first fixed area 392A may be fixed to the first housing 310 and at least a portion of the second fixed area 392B may be fixed to the second housing 320. In one embodiment, the first fixed area 392A may include a first extension portion 3921 extending from the first bending portion 3912a in a direction (e.g., the -X direction of FIG. 3B) opposite to the central portion 3911. The second fixed area 392B may include a second extension portion 3922 extending from the second bending portion 3912b in a direction (e.g., the +X direction of FIG. 3B) opposite to the central portion 3911.

In one embodiment, at least a portion of the first extension portion 3921 may be fixed to the first housing 310. For example, an end, connected to the first bending portion 3912a, of the first extension portion 3921 may be fixed to the first support plate 331. The first extension portion 3921 may pass through the first opening 331a and may extend from the surface of the first support plate 331 to the inside the first space 310a. An end of the first extension portion 3921 extending to the inside the first space 310a may be fixed in the first space 310a. For example, the end of the first extension portion 3921 extending to the inside the first space 310a may be connected to a component arranged in the first space 310a, for example, a first PCB (e.g., the first PCB 271 of FIG. 2C). In one embodiment, at least a portion of the second extension portion 3922 may be fixed to the second housing 320. For example, an end, connected to the second bending portion 3912b, of the second extension portion 3922 may be fixed to the second support plate 332. The second extension portion 3922 may pass through the second opening 332a and may extend from the surface of the second support plate 332 to the inside of the second space 320a. An end of the second extension portion 3922 extending to the inside of the second space 320a may be fixed in the second space 320a. For example, the end of the second extension portion 3922 extending to the inside of the second space 320a may be connected to a component arranged in the second space 320a, for example, a second PCB (e.g., the second PCB 272 of FIG. 2C).

In one embodiment, the FPCB 390 may be fixed to the first support plate 331 and the second support plate 332. In one embodiment, the FPCB 390 may include a first fastening member 3931 fixed to the first support plate 331 and a second fastening member 3932 fixed to the second support plate 332. For example, in the first state as illustrated in FIG. 3B, the first fastening member 3931 may fix a portion of the FPCB 390 to the surface of the first support plate 331 facing the display 350 and the second fastening member 3932 may fix a portion of the FPCB 390 to the surface of the second support plate 332 facing the display 350. In one embodiment, a fastening member 393 may be coupled to the surface of the first or second support plate 331 or 332 through a coupling member (e.g., a screw and a fastener). In one embodiment, based on a state (or direction) in which the display 350 is viewed (e.g., a state of viewing in the -Z direction of FIG. 3B), the first fastening member 3931 may overlap the driving area 391 and the first fixed area 392A. That is, in an example, when the display 350 is viewed from above (e.g. when viewed downward, or -Z direction), the first fastening member 3931 may be seen to overlap the driving area 391 and the first fixed area 392A. For example, the first fastening member 3931 may overlap the first bending portion 3912a and the first extension portion 3921. In one embodiment, based on a state in which the display 350 is viewed (e.g., a state of viewing in the -Z direction of FIG. 3B), the second fastening member 3932 may overlap the driving area 391 and the second fixed area 392B. That is, in an example, when the display 350 is viewed from above (e.g. when viewed downward, or -Z direction), the second fastening member 3932 may be seen to overlap the driving area 391 and the second fixed area 392B For example, the second fastening member 3932 may overlap the second bending portion 3912b and the second extension portion 3922.

In one embodiment, as the shape and the position of the driving area 391 relative to the hinge housing 334 changes in response to a change in a folding angle, the whole shape of the FPCB 390 may change in response to the shape of the electronic device 301. For example, when the electronic device 301 changes from the first state (e.g., the unfolded state of FIG. 3B) to the second state (e.g., the folded state of FIG. 3C), the position (e.g., a position in the Z-axis direction) of the driving area 391 relative to the hinge housing 334 may change while simultaneously the first bending portion 3912a and the second bending portion 3912b are bent and the shape of the driving area 391 changes in response to the change in the folding angle of the electronic device 301. In this case, the first fixed area 392A and the second fixed area 392B of the FPCB 392 may maintain constant shapes (e.g. may maintain, or substantially maintain a current shape) in the electronic device 301 as the first fixed area 392A and the second fixed area 392B are partially fixed to the first housing 310 and the second housing 320, respectively. For example, the first fixed area 392A and the second fixed area 392B may maintain relatively constant shapes compared to the driving area 391. In one embodiment, in response to a change in a folding angle of the electronic device 301, relatively greater stress may be concentrated on the driving area 391 than the fixed area. That is, as the fixed areas (392A and 392B) of the FPCB 390 may be at least partially fixed to the respective housing, the shape (or position) of these areas of the FPCB 390 remains substantially constant (e.g. experiences a very small amount of bend when a folding angle of the electronic device 301 is changed), and these areas experience reduced stress in comparison to the driving area 391 (e.g. first and second bending portions 3912a and 3912b) which may be deformed, or bent, in shape in response to the change of folding angle.

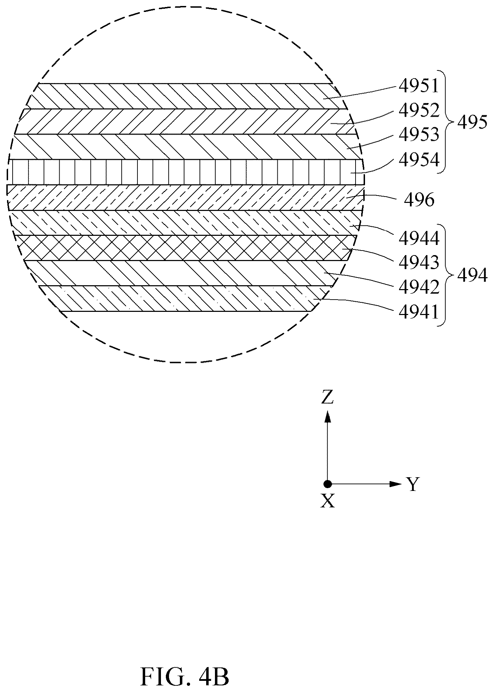

FIG. 4A is a perspective view of an FPCB according to one embodiment, and FIG. 4B is a cross-sectional view of an FPCB taken along the line A-A of FIG. 4A.

Referring to FIGS. 4A and 4B, the FPCB 390 (e.g., the FPCB 290 of FIG. 2C) in one embodiment may include the driving area 391, the first fixed area 392A, and the second fixed area 392B divided in an extending direction (e.g., the X-axis direction, along a longitudinal length of the FPCB, that is, along a direction in which the FPCB extends). In one embodiment, the first fixed area 392A and the second fixed area 392B may be connected to the driving area 391 opposite to each other (e.g. may form a fixed area of the FPCB 390 either side of the driving area 391). For example, based on FIG. 4A, the first fixed area 392A may be connected to the left side (e.g., the -X-axis direction) of the driving area 391 and the second fixed area 392B may be connected to the right side (e.g., the +X-axis direction) of the driving area 391. In one embodiment, the first fastening member 3931 may be arranged on a connecting part of the driving area 391 to the first fixed area 392A and the second fastening member 3932 may be arranged on a connecting part of the driving area 391 to the second fixed area 392B.

In one embodiment, the driving area 391 may include the central portion 3911 arranged in a hinge housing (e.g., the hinge housing 334 of FIG. 3B), the first bending portion 3912a extending from the central portion 3911 to the first fastening member 3931 and at least partially bending, and the second bending portion 3912b extending from the central portion 3911 to the second fastening member 3932 and at least partially bending.

In one embodiment, the first fixed area 392A may include the first extension portion 3921 extending from the first fastening member 3931 in a direction opposite to the central portion 3911. The second fixed area 392B may include the second extension portion 3922 extending from the second fastening member 3932 in a direction opposite to the central portion 3911. In one embodiment, at least a portion of the first extension portion 3921 may be fixed to a first housing (e.g., the first housing 310 of FIG. 3B) and at least a portion of the second extension portion 3922 may be fixed to a second housing (e.g., the second housing 320 of FIG. 3B). In one embodiment, a first connector 398a for connecting to a first component (e.g., the first PCB 271 of FIG. 2C) arranged in the first housing may be arranged on the first extension portion 3921. A second connector 398b for connecting to a second component (e.g., the second PCB 272 of FIG. 2C) arranged in the second housing may be arranged on the second extension portion 3922.

In one embodiment, the FPCB 390 may comprise a multi-layer structure. That is, the FPCB 390 may be formed of a plurality of layers (or layer parts). In one embodiment, based on a cross-sectional view, the FPCB 390 may include (or be formed of) a first layer part 494, a second layer part 495, and a connecting layer 496 connecting the first layer part 494 to the second layer part 495. In one embodiment, as illustrated in FIG. 4B, the FPCB 390 may be arranged (or positioned) inside an electronic device such that the first layer part 494 faces the hinge housing and the second layer part 495 faces the rear surface of a display.

In one embodiment, the first layer part 494 may include (e.g. may be formed of) a first base layer 4944, a first metal layer 4943, a first adhesive layer 4942, and a first cover layer 4941.

In one embodiment, the first base layer 4944 may comprise (or be formed of) a PI material. In one embodiment, the first base layer 4944 may include a first base surface and a second base surface opposite to the first base surface. In one embodiment, based on a state in which the FPCB 390 is arranged (or positioned) inside the electronic device, as illustrated in FIG. 4B, the first base surface may face the rear surface (e.g., the +Z-axis direction) of the display and the second base surface may face the hinge housing (e.g., the -Z-axis direction).

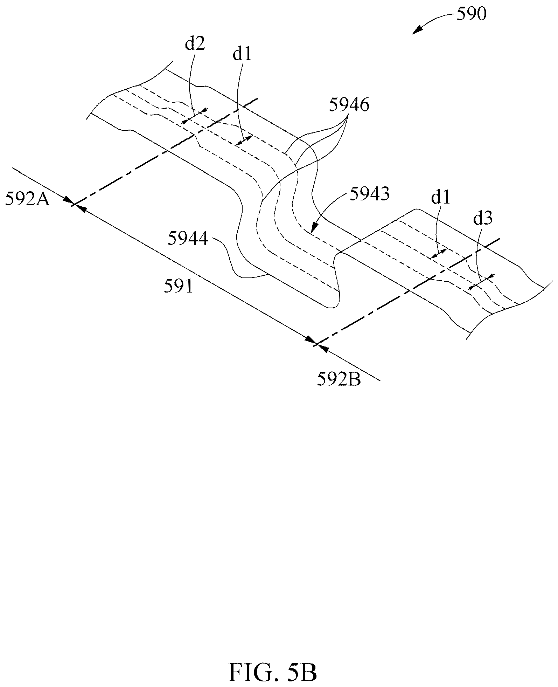

In one embodiment, the first metal layer 4943 may be arranged on the first base surface of the first base layer 4944. The first metal layer 4943 may be formed of a conductive material, for example, copper (Cu). In one embodiment, the first metal layer 4943 may form a plurality of signal lines (e.g., a signal line 5946 of FIG. 5B) formed in an extending direction (e.g., along the X-axis) of the first base surface (e.g. of first base layer 4944). For example, a pattern of the plurality of signal lines for transmitting a signal may be formed on the first metal layer 4943 through a process, such as etching. The plurality of signal lines may be formed to pass through the driving area 391 and extend from (and transmit signals from) the first fixed area 392A to the second fixed area 392B. In one embodiment, a signal line formed in the first metal layer 4943 may be formed in a substantially straight line in an extending direction to perform high-speed signal transmission.

In one embodiment, the first cover layer 4941 may be stacked in a direction of the second base surface to cover the first metal layer 4943, for example, the plurality of signal lines. By covering the surface of the first metal layer 4943, the first cover layer 4941 may prevent damage to the plurality of signal lines formed on the first metal layer 4943. The first cover layer 4941 may be formed of a dielectric material. For example, the first cover layer 4941 may be formed of PET. In one embodiment, the first cover layer 4941 may have a different thickness depending on an area of the FPCB 390. A description thereof is provided later.

In one embodiment, the first adhesive layer 4942 may be arranged, or positioned, between the first metal layer 4943 and the first cover layer 4941. In one embodiment, the first adhesive layer 4942 may connect the first metal layer 4943 to the first cover layer 4941 to fill an empty space of the first metal layer 4943 of which the surface is etched to form a pattern of the signal line.

In one embodiment, the second layer part 495 may be stacked on the first layer part 494 in a direction of the first base surface of the first base layer 4944. In one embodiment, the second layer part 495 may include a second base layer 4954, a second metal layer 4953, a second adhesive layer 4952, and a second cover layer 4951.

In one embodiment, the second base layer 4954 may be stacked on the first base layer 4944 to be opposite to the first metal layer 4943. For example, the second base layer 4954 may be stacked in the direction of the first base surface of the first base layer 4944. In one embodiment, the first base layer 4944 may include a PI material.

In one embodiment, the second metal layer 4953 may be arranged on the surface of the second base layer 4954 to be opposite to the first base layer 4944. The second metal layer 4953 may be formed a conductive material, for example, copper (Cu). In one embodiment, the second metal layer 4953 may form a signal line extending from the first fixed area 392A to the second fixed area 392B. In one embodiment, the second cover layer 4951 may be arranged on the second base layer 4954 to cover the second metal layer 4953. The second cover layer 4951 may be formed of a dielectric material, for example, PET. In one embodiment, the second cover layer 4951 may be integrally formed to continue in the first fixed area 392A, the driving area 391, and the second fixed area 392B. In one embodiment, the second adhesive layer 4952 may be between the second metal layer 4953 and the second cover layer 4951. In one embodiment, the second adhesive layer 4952 may connect the second metal layer 4953 to the second cover layer 4951 to fill an empty space of the second metal layer 4953 of which the surface is etched to form a pattern of the signal line.

In one embodiment, a connecting layer 496 may be disposed between the first layer part 494 and the second layer part 495. In one embodiment, the connecting layer 496 may be formed of, for example, a polypropylene (PP) material.

In one embodiment, when the FPCB 390 is formed having a double-layer structure including the first layer part 494 and the second layer part 495, in comparison to a larger number of layers of a FPCB structure, for example, the thickness of the FPCB 390 may therefore be decreased , and the thickness of an electronic device (e.g., the electronic device 301 of FIG. 3A) may therefore also decrease. That is, the double-layer structure, according to the examples described, may reduce a thickness of the electronic device.

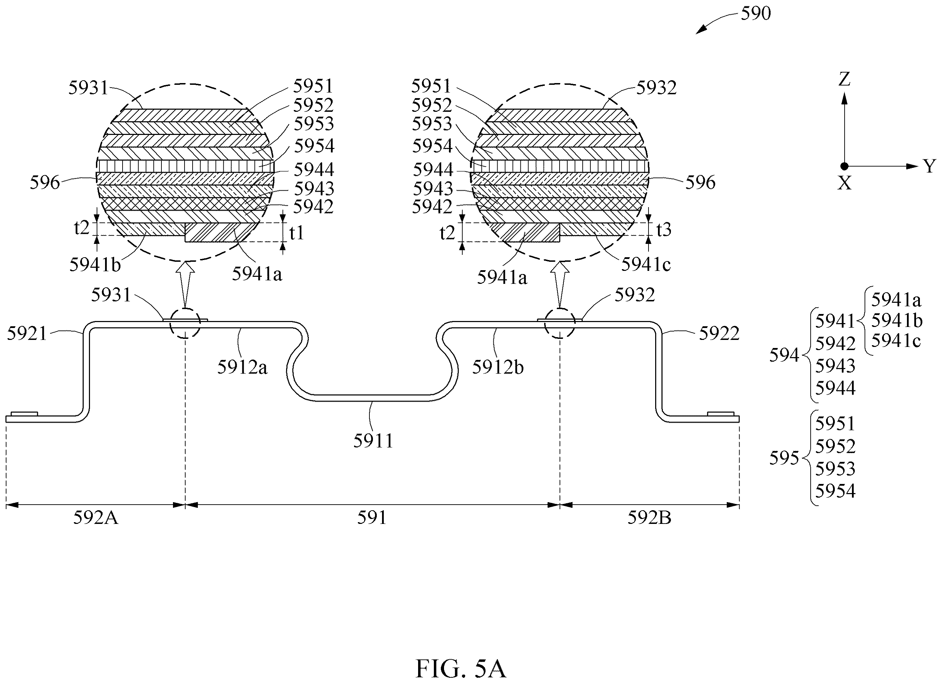

FIG. 5A is a cross-sectional view of an FPCB according to one embodiment, and FIG. 5B is a view of an example of a plurality of signal lines according to one embodiment.

Referring to FIGS. 5A and 5B, an FPCB 590 (e.g., the FPCB 290 of FIG. 2C and the FPCB 390 of FIG. 4A) in an embodiment may include a driving area 591, a first fixed area 592A, and a second fixed area 592B. The FPCB 590 may be formed such that the thickness of the driving area 591 is different from at least one of the thickness of the first fixed area 592A and the thickness of the second fixed area 592B. For example, the thickness of the driving area 591 may be greater than the thickness of the first fixed area 592A and the thickness of the second fixed area 592B.

In one embodiment, the FPCB 590 may include a first layer part 594, a second layer part 595, and a connecting layer 596 connecting the first layer part 594 to the second layer part 595. In an embodiment, the first layer part 594 include a first base layer 5944, a first metal layer 5943, a first adhesive layer 5942, and a first cover layer 5941. The second layer part 595 include a second base layer 5954, a second metal layer 5953, a second adhesive layer 5952, and a second cover layer 5951. In one embodiment, the thickness of the driving area 591 of the first layer part 594 may be different from the thickness of the first layer part 594 in the first fixed area 592A and the thickness of the second fixed area 592B.

In one embodiment, the first cover layer 5941 may include a first cover portion 5941a arranged in the driving area 591 and having a first thickness t1, a second cover portion 5941b arranged in the first fixed area 592A and having a second thickness t2 that is different from the first thickness t1, and a third cover portion 5941c arranged in the second fixed area 592B and having a third thickness t3 that is different from the first thickness t1. In one embodiment, the first cover portion 5941a, the second cover portion 5941b, and the third cover portion 5941c may be separately formed. For example, the first cover portion 5941a, the second cover portion 5941b, and the third cover portion 5941c may be individually formed and arranged on the first base layer 5944 to cover the first metal layer 5943. In one embodiment, based on an extending direction (e.g., the X-axis direction), a first fastening member 5931 may be arranged on a boundary of a first cover portion 5941a and a second cover portion 5941b and a second fastening member 5932 may be arranged on a boundary of the first cover portion 5941a and a third cover portion 5941c.

In one embodiment, the first thickness t1 of the first cover portion 5941a may be greater than the second thickness t2 of the second cover portion 5941b and the third thickness t3 of the third cover portion 5941c. For example, the first thickness t1 may be about twice the second thickness t2 or the third thickness t3. In one embodiment, the second thickness t2 of the second cover portion 5941b may be substantially the same as the third thickness t3 of the third cover portion 5951c. In one example, the first thickness t1 may be greater than both the second thickness t2 and third thickness t3, wherein the second thickness t2 and third thickness t3 are substantially the same. In one embodiment, when the first thickness t1 of the first cover portion 5941a is greater than the second thickness t2 of the second cover portion 5941b and the third thickness t3 of the third cover portion 5941c, the durability of the driving area 591 that changes its shape in response to a change in a folding angle may be improved compared to the fixed area, for example, the first fixed area 592A or the second fixed area 592B. As the first or second fixed area 592A or 592B maintains a substantially constant shape regardless of a change in a folding angle, a space occupied by the FPCB 590 in the first housing (e.g., the first housing 310 of FIG. 3B) and the second housing (e.g., the second housing 320 of FIG. 3B) may decrease as the first or second fixed area 592A or 592B by reducing the thickness (e.g. a second thickness t2 and third thickness t3) such as compared to the driving area 591 (e.g. a first thickness t1).

In one embodiment, a plurality of signal lines 5946 formed by the first metal layer 5943 may form, on the first base layer 5944, a wiring pattern in a substantially straight line shape in an extending direction (e.g., the X-axis direction) for transmitting a high-speed signal. In one embodiment, the plurality of signal lines 5946 may be arranged to extend in the extending direction and form intervals between each other (e.g. an interval, distance or spacing, between each of the plurality of signal lines 5946). In one embodiment, the intervals between the plurality of signal lines 5946 may be different depending on an area of the FPCB 590. For example, the plurality of signal lines 5946 may be arranged to form a first interval d1 between each other in the driving area 591. That is, a distance or spacing between signal lines (of the plurality of signal lines 5946 formed) in the driving area 591 may be at an interval (or spacing) of d1. The plurality of signal lines 5946 may be arranged to form a second interval d2 that is different from the first interval d1 between each other in the first fixed area 592A. That is, a distance or spacing between signal lines (of the plurality of signal lines 5946 formed) in the first fixed area 592A may be at an interval (or spacing) of d2. The plurality of signal lines 5946 may be arranged to form a third interval d3 that is different from the first interval d1 between each other in the second fixed area 592B. In one embodiment, the second interval d2 between the plurality of signal lines 5946 in the first fixed area 592A may be less than the first interval d1 between the plurality of signal lines 5946 in the driving area 591. In one embodiment, the third interval d3 between the plurality of signal lines 5946 in the second fixed area 592B may be less than the first interval d1 between the plurality of signal lines 5946 in the driving area 591. In one embodiment, the second interval d2 may be substantially the same as the third interval d3. In an example, the second interval d2 and third interval d3 may be substantially the same, and less than the first interval d1. In one embodiment, the first interval d1 between the plurality of signal lines 5946 in the driving area 591 may be about 1.2 times of the second interval d2 and the third interval d3 between the plurality of signal lines 5946 in the first fixed area 592A and the second fixed area 592B.

In one embodiment, the FPCB 590 may adjust an impedance difference among the driving area 591, the first fixed area 592A, and the second fixed area 592B to be within a set range through a thickness difference of areas of the first cover layer 5941 and an interval difference between the plurality of signal lines 5946 formed by the first metal layer 5943. That is, in other words, by the thickness differences of the first cover layer 5941 and/or the interval difference between the plurality of signal lines 5946 formed by the first metal layer 5943, the FPCB 590 may substantially match an impedance for the entire area. In one embodiment, an impedance value generated in each area of the FPCB 590 may increase as the thickness of the first cover layer 5941 formed of a dielectric material increases. In one embodiment, the impedance value generated in each area of the FPCB 590 may increase as the interval between the plurality of signal lines 5946 formed by the first metal layer 5943 decreases. In one embodiment, the FPCB 590 may provide an impedance match of the entire area by forming the first thickness t1 of the first cover portion 5951a in the driving area 591 to be greater than the second thickness t2 of the second cover portion 5951b in the first fixed area 592A and the third thickness t3 of the third cover portion 5951c in the second fixed area 592B and forming the first interval d1 between the plurality of signal lines 5946 in the driving area 591 to be greater than the second interval d2 between the plurality of signal lines 5946 in the first fixed area 592A and the third interval d3 between the plurality of signal lines 5946 in the second fixed area 592B.

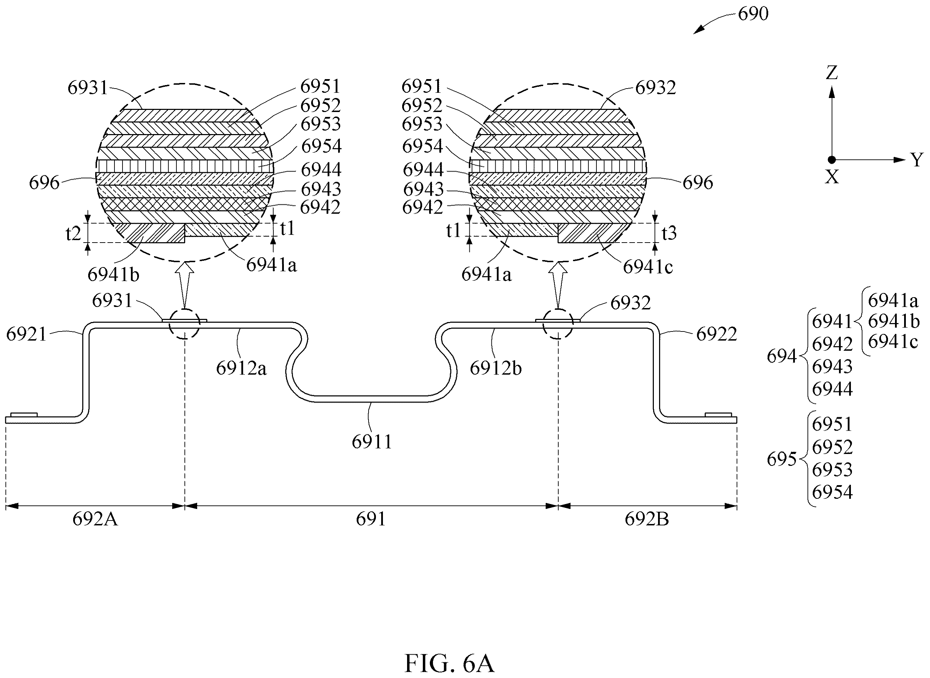

In another example, the first cover layer may have a thickness less in the driving area than a thickness in the first and second fixed areas. The first cover layer 5941 may have a thickness between 10 µm and 15 µm in the driving area 591. In one embodiment, the first cover layer 5941 may have a thickness between 12 µm and 13 µm in the driving area 591. In one embodiment, the first cover layer 5941 may have a thickness of about 12.5 µm in the driving area 591. In one embodiment, the first cover layer 5941 may have a thickness between 20 µm and 30 µm in the first fixed area 592A and the second fixed area 592B. In one embodiment, the first cover layer 5941 may have a thickness between 24 µm and 26 µm in the first fixed area 592A and the second fixed area 592B. In one embodiment, the first cover layer 5941 may have a thickness of about 25 µm in the first fixed area 592A and the second fixed area 592B. An example where the first cover layer 5941 has a larger thickness in the first fixed area 592A and second fixed area 592B than the thickness of the driving area 591 is illustrated in Figure 6A-B.

In an example the plurality of signal lines 5946 formed by the first metal layer 5943 may be arranged to form an interval (e.g. interval d1) between each other between 45 µm and 55 µm in the driving area 591. Preferably, the plurality of signal lines 5946 formed by the first metal layer 5943 may be arranged to form an interval between each other between 49 µm and 51 µm in the driving area 591. More preferably, the plurality of signal lines 5946 formed by the first metal layer 5943 may be arranged to form an interval between each other about 50 µm in the driving area 591. In one embodiment, the plurality of signal lines 5946 formed by the first metal layer 5943 may be arranged to form an interval (e.g. respective intervals d2 and d3) between 54 µm and 66 µm between the first fixed area 592A and the second fixed area 592B. Preferably, the plurality of signal lines 5946 formed by the first metal layer 5943 may be arranged to form an interval between 59 µm and 61 µm between the first fixed area 592A and the second fixed area 592B. More preferably, the plurality of signal lines 5946 formed by the first metal layer 5943 may be arranged to form an interval of about 60 µm between the first fixed area 592A and the second fixed area 592B. An example where the plurality of signal lines are arranged to form a second and third interval in the respective first and second areas that is greater than the first interval formed between each other in the driving area is illustrated with reference to Figure 6A-B.

Table 1 shown below may represent an example of adjusting the thickness of the first cover layer 5941 and an interval between the plurality of signal lines 5946 formed by the first metal layer 5943 to match impedances of each area of the FPCB 590. However, numerical values shown below are only an example for an impedance match and are not limited thereto.

**[Table 1]**

| | Driving area | First fixed area | Second fixed area |
|---|---|---|---|
| First cover layer thickness (µm) | 25 | 12.5 | 12.5 |
| First adhesive layer thickness (µm) | 15 | 15 | 15 |
| First metal layer thickness (µm) | 12 | 12 | 12 |
| Intervals between signal lines (µm) | 60 | 50 | 50 |
| First base layer thickness (µm) | 12 | 12 | 12 |
| Impedance value (ohms) | 87 | 85 | 85 |

In one embodiment, an impedance value of the FPCB 590 may increase as the thickness of the first cover layer 5941 formed of a dielectric material increases and may decrease as an interval between signal lines increases. In one embodiment, the FPCB 590 may maintain impedance values of the driving area 591 and the fixed area to be within a set range by forming an interval between signal lines in the driving area 591 to be greater than an interval between signal lines in the fixed area while simultaneously improving the durability of the driving area 591 compared to the fixed area by increasing the thickness of the first cover layer 5941 in the driving area 591 compared to the fixed area.

For example, the first cover layer 5941 may have a thickness of about 25 µm in the driving area 591 and may have a thickness of about 12.5 µm in the fixed area. Simultaneously, the plurality of signal lines formed on the first metal layer 5943 may have an interval of about 60 µm between each other in the driving area 591 and may have an interval of about 50 µm between each other in the fixed area. In this case, as a result of measuring impedance values of the driving area 591 and the fixed area, it may be identified that high impedance matching performance is implemented because an impedance difference between these areas is about 2% as the impedance value of the driving area 591 is about 87 ohms and the impedance value of the fixed area is about 85 ohms.

However, the numerical values shown in the above table are arbitrarily determined to describe an impedance matching effect through adjusting the thickness of the first cover layer 5941 and the interval between signal lines, and the thickness difference of the first cover layer 5941 and the interval difference between signal lines applied to various embodiments are not limited to the numerical values shown in Table 1. In other words, it will be generally be appreciated that an impedance matching effect may be performed by means of adjustment (or difference) in the thickness of the first cover layer 5941 between driving area and fixed areas of the FPCB 590, and/or adjustment (or difference) in an interval between signal lines in the driving areas and the fixed areas of the FPCB, without being limited to the numerical values as described.

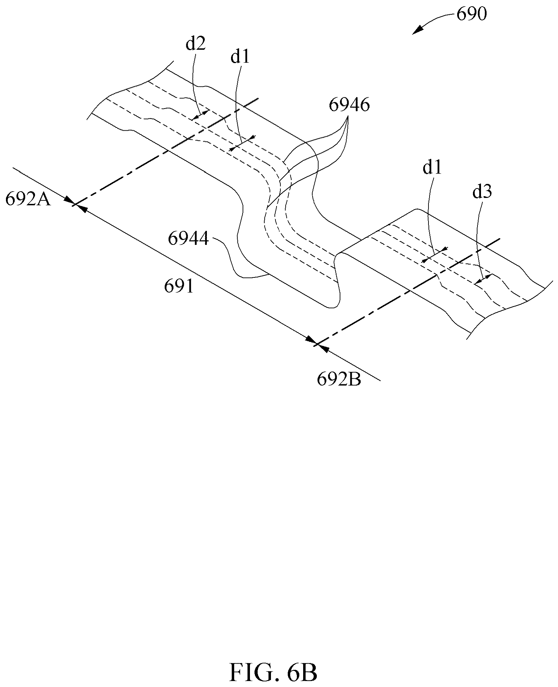

FIG. 6A is a cross-sectional view of an FPCB according to one embodiment and FIG. 6B is a view of an example of a plurality of signal lines according to one embodiment.

Referring to FIGS. 6A and 6B, an FPCB 690 (e.g., the FPCB 290 of FIG. 2C, the FPCB 390 of FIG. 3A, or the FPCB 490 of FIG. 4) in an embodiment may include a driving area 691, a first fixed area 692A, and a second fixed area 692B. In one embodiment, the thickness of the driving area 691 of the FPCB 690 may be less than at least one of the thickness of the first fixed area 692A and the thickness of the second fixed area 692B.

In one embodiment, the FPCB 690 may include a first base layer 6944, a first metal layer 6943, a first adhesive layer 6942, a first layer part 694 including a first cover layer 6941, a second base layer 6954, a second metal layer 6953, a second adhesive layer 6952, a second layer part 695 including a second cover layer 6951, and a connecting layer 696 connecting the first layer part 694 to the second layer part 695. In one embodiment, the thickness of the driving area 691 of the first layer part 694 may be less than the thickness of the first fixed area 692A and the thickness of the second fixed area 692B.

In one embodiment, the first cover layer 6941 may include a first cover portion 6941a arranged in the driving area 691 and having a first thickness t1, a second cover portion 6941b arranged in the first fixed area 692A and having a second thickness t2 that is greater than the first thickness t1, and a third cover portion 6941c arranged in the second fixed area 692B and having a third thickness t3 that is greater than the first thickness t1. In one embodiment, the first thickness t1 of the first cover portion 6941a may be less than the second thickness t2 of the second cover portion 6941b and the third thickness t3 of the third cover portion 6941c. For example, the second thickness t2 and the third thickness t3 may be about twice the first thickness t1. In one embodiment, when the second thickness t2 of the second cover portion 6941b and the third thickness t3 of the third cover portion 6941c are greater than the first thickness t1 of the first cover portion 6941a, durability of the first fixed area 692A and durability of the second fixed area 692B may be improved compared to the durability of the driving area 691. In this case, while the first fixed area 692A and the second fixed area 692B are respectively fixed to the first housing (e.g., the first housing 310 of FIG. 3B) and the second housing (e.g., the second housing 320 of FIG. 3B), damage to the first fixed area 692A and the second fixed area 692B may be mitigated.

In one embodiment, the first cover portion 6941a, the second cover portion 6941b, and the third cover portion 6941c may be separately formed. In one embodiment, based on an extending direction (e.g., the X-axis direction), a first fastening member 6931 may be arranged on a boundary of the first cover portion 6941a and the second cover portion 6941b and a second fastening member 6932 may be arranged on a boundary of the first cover portion 6941a and the third cover portion 6941c.

In one embodiment, a plurality of signal lines 6946 formed by the first metal layer 6943 may form a wiring pattern in a substantially straight line shape in an extending direction (e.g., the X-axis direction) for transmitting a high-speed signal. In one embodiment, the plurality of signal lines 6946 may be arranged to extend in the extending direction and form intervals between each other.

In one embodiment, an interval between the plurality of signal lines 6946 may be substantially the same or different by the area of the FPCB, e.g. in the driving area 691, the first fixed area 692A, and the second fixed area 692B. For example, the plurality of signal lines 6946 may be arranged to form a first interval d1 between each other in the driving area 691. The plurality of signal lines 6946 may be arranged to form a second interval d2 that is substantially the same or different from the first interval d1 between each other in the first fixed area 692A. The plurality of signal lines 6946 may be arranged to form a third interval d3 that is substantially the same or greater than the first interval d1 between each other in the second fixed area 692B. In one embodiment, the second interval d2 may be substantially the same as the third interval d3. In one embodiment, the second interval d2 and the third interval d3 between the plurality of signal lines 6946 in the fixed area may be about 1.2 times of the first interval d1 between the plurality of signal lines 6946 in the driving area.

In one embodiment, when intervals between the plurality of signal lines 6946 in each of the driving, first fixed, and second fixed areas 691, 692A, and 692B of the FPCB 690 are substantially the same, the first cover layer 6941 and the first adhesive layer 6942 of the FPCB 690 may be formed to have different thicknesses in each of the driving, first fixed, and second fixed areas 691, 692A, and 692B for impedance matching in each of the driving, first fixed, and second fixed areas 691, 692A, and 692B of the FPCB 690. In one embodiment, because the first cover layer 6941 and the first adhesive layer 6942 include a dielectric material, the first cover layer 6941 and the first adhesive layer 6942 may have a complementary thickness difference depending on each of the driving, first fixed, and second fixed areas 691, 692A, and 692B of the FPCB 690, and thus, an impedance difference of the FPCB 690 may be in a set range. For example, when the thickness t1 in the driving area 691 of the first cover layer 6941 is greater than the thickness t2 in the first fixed area 692A and the thickness t3 in the second fixed area 692B, the thickness of the first adhesive layer 6942 in the driving area 691 may be less than the thickness of the first adhesive layer 6942 in the first or second fixed area 692A or 692B, and thus, an impedance difference for each of the driving, first fixed, and second fixed areas 691, 692A, and 692B based on a thickness difference of the first cover layer 6941 may be offset. For example, when the plurality of signal lines 6946 formed on the FPCB 690 has a predetermined pattern interval, an impedance difference of each of the driving, first fixed, and second fixed areas 691, 692A, and 692B of the FPCB 690 may decrease through a thickness difference of each of the driving, first fixed, and second fixed areas 691, 692A, and 692B of the first adhesive layer 6942 and the first cover layer 6941.

According to one embodiment, the electronic device 101, 201, or 301 may include the display 250 or 350 including the first area 250a or 350a and the second area 250b or 350b, the first housing 210 or 310 supporting the first area 250a or 350a, the second housing 220 or 320 supporting the second area 250b or 350b, the hinge structure 340 foldably connecting the first housing 210 or 310 to the second housing 220 or 320 based on the folding axis A and adjusting a folding angle formed by the first housing 210 or 310 and the second housing 220 or 320 relative to the folding axis A, and the FPCB 290, 390, 590, or 690 extending in an extending direction. In one embodiment, the FPCB 290, 390, 590, or 690 may include the driving area 391, 591, or 691 traversing the folding axis A and at least partially bending in response to a change in the folding angle, the first fixed area 392A, 592A, or 692A extending from the driving area 391, 591, or 691 to the first space 210a or 310a formed by the first housing 210 or 310, and the second fixed area 392B, 592B, or 692B extending from the driving area 391, 591, or 691 to the second space 220a or 320a formed by the second housing 220 or 320. In one embodiment, the FPCB 290, 390, 590, or 690 may include the first base layer 4944, 5944, or 6944 including the first base surface and the second base surface opposite to the first base surface, the first metal layer 4943, 5943, or 6943 arranged on the second base surface and forming a plurality of signal lines 4946 extending in the extending direction, and the first cover layer 4941, 5941, or 6941 arranged to cover the first metal layer 4943, 5943, or 6943 in a direction of the second base surface. In one embodiment, the thickness t1 of the first cover layer 4941, 5941, or 6941 in the driving area 391, 591, or 691 is different from the thickness t2 or t3 of the first cover layer 4941 in the first fixed area 392A, 592A, or 692A or the second fixed area 392B, 592B, or 692B.

In one embodiment, the first cover layer 4941, 5941, or 6941 may include the first cover portion 4941a, 5941a, or 6941a arranged in the driving area 491, 591, or 691 and having the first thickness t1, the second cover portion 4941b, 5941b, or 6941b arranged in the first fixed area 492A, 592A, or 692A and having the second thickness t2 that is different from the first thickness t2, and the third cover portion 4941c, 5941c, or 6941c arranged in the second fixed area 492B, 592B, or 692B and having the third thickness t3 that is different from the first thickness t1.

In one embodiment, the first cover portion 4941a, 5941a, or 6941a, the second cover portion 4941b, 5941b, or 6941b, and the third cover portion 4941c, 5941c, or 6941c may be separately formed. In this case, each of the cover portions having different thicknesses may be separately manufactured and arranged on the first base layer.

In one embodiment, the plurality of signal lines 5946 or 6946 may be arranged to extend in the extending direction and such that intervals are formed between the signal lines. In one embodiment, the interval d1 between the plurality of signal lines 5946 or 6946 in the driving area 491, 591, or 691 may be different from the interval d2 or d3 between the plurality of signal lines 5946 or 6946 in the first fixed area 492A, 592A, or 692A or in the second fixed area 492B, 592B, or 692B. In this case, an impedance difference may occur according to an interval difference between the signal lines in each area of the FPCB.

In one embodiment, the first thickness t1 may be greater than the second thickness t2 and the third thickness t3. In this case, an impedance difference may occur according to the thickness of the first cover layer formed of a dielectric material.

In one embodiment, the plurality of signal lines 5946 may be arranged to form the first interval d1 between each other in the driving area 591. In one embodiment, the plurality of signal lines 5946 may be arranged to form the second interval d2 that is less than the first interval d1 between each other in the first fixed area 592A. In one embodiment, the plurality of signal lines 5946 may be arranged to form the third interval d3 that is less than the first interval d1 between each other in the second fixed area 592B.

In one embodiment, the first cover layer 5941 may have a thickness of 10 µm to 15 µm in the driving area 591. In one embodiment, the first cover layer 5941 may have a thickness of 20 µm to 30 µm in the first fixed area 592A and the second fixed area 592B. In one embodiment, the plurality of signal lines 5946 may be arranged to form an interval of 45 µm to 55 µm between each other in the driving area 591. In one embodiment, the plurality of signal lines 5946 may be arranged to form an interval of 54 µm to 66 µm between each other in the first fixed area 592A and the second fixed area 592B.

In one embodiment, the first thickness t1 may be less than the second thickness t2 and the third thickness t3.

In one embodiment, the plurality of signal lines 6946 may be arranged to form the first interval d1 between each other in the driving area 691. In one embodiment, the plurality of signal lines 6946 may be arranged to form the second interval d2 that is greater than the first interval d1 between each other in the first fixed area 692A. In one embodiment, the plurality of signal lines 6946 may be arranged to form the third interval d3 that is less than the first interval d1 between each other in the second fixed area 692B.

In one embodiment, the first cover layer 6941 may have a thickness of 20 µm to 30 µm in the driving area 601. In one embodiment, the first cover layer 6941 may have a thickness of 10 µm to 15 µm in the first fixed area 692A and the second fixed area 692B. In one embodiment, the plurality of signal lines 6946 may be arranged to form an interval of 55 µm to 65 µm between each other.

In one embodiment, the hinge structure 340 may further include the first support plate 331 connecting the first housing 310 to the hinge housing 346, and the second support plate 332 connecting the second housing 320 to the hinge housing 346. In one embodiment, the FPCB 290, 390, 590, or 690 may further include the first fastening member 3931, 5931, or 6931 fixed to the first support plate 331, and the second fastening member 3932, 5932, or 6932 fixed to the second support plate 332.

In one embodiment, based on a state in which the display 350 is viewed, the first fastening member 3931, 5931, or 6931 may overlap the driving area 391, 591, or 691 and the first fixed area 392A, 592A, or 692A. In one embodiment, the second fastening member 3932, 5932, or 6932 may overlap the driving area 391, 591, or 691 and the second fixed area 392B, 592B, or 692B.

In one embodiment, based on the extending direction, the driving area 391, 591, or 691 may include the central portion 3911, 5911, or 6911 arranged in the hinge housing 334, the first bending portion 3912a, 5912a, or 6912a extending from the central portion 3911, 5911, or 6911 to the first fastening member 3931, 5931, or 6931 and at least partially bending, and the second bending portion 3912b, 5912b, or 6912b extending from the central portion 3911, 5911, or 6911 to the second fastening member 3932, 5932, or 6932 and at least partially bending. In one embodiment, the first fixed area 392A, 592A, or 692A may include the first extension portion 3921, 5921, or 6921 extending from the first fastening member 3931, 5931, or 6931 in a direction opposite to the central portion 3911, 5911, or 6911 and at least partially fixed to the first housing 210 or 310. In one embodiment, the second fixed area 392B, 592B, or 692B may include the second extension portion 3922, 5922, or 6922 extending from the second fastening member 3932, 5932, or 6932 in a direction opposite to the central portion 3911, 5911, or 6911 and at least partially fixed to the second housing 220 or 320.

In one embodiment, the FPCB 390, 590, or 690 may further include the second base layer 4954, 5954, or 6954 arranged on the first base layer 4944, 5944, or 6944 to be opposite to the first metal layer 4943, 5943, or 6943, the second metal layer 4953, 5953, or 6953 arranged on the second base layer 4954, 5954, or 6954 to be opposite to the first base layer 4944, 5944, or 6944, and the second cover layer 4951, 5951, or 6951 arranged on the second base layer 4954, 5954, or 6954 to cover the second metal layer 4953, 5953, or 6953.

In one embodiment, the FPCB 390, 590, or 690 may be arranged such that the first base surface faces a rear surface of the display 250 or 350.

According to one embodiment, the FPCB 290, 390, 590, or 690 arranged in the electronic device 201 or 301, the FPCB 290, 390, 590, or 690 may include the first base layer 4944, 5944, or 6944 including the first base surface and the second base surface opposite to the first base surface, the first metal layer 4943, 5943, or 6943 arranged on the second base surface and forming the plurality of signal lines 5946 or 6946 arranged in the extending direction, the first cover layer 4941, 5941, or 6941 arranged to cover the first metal layer 4943, 5943, or 6943 in a direction of the second base surface, the second base layer 4954, 5954, or 6954 arranged in a direction of the first base surface, the second metal layer 4953, 5953, or 6953 arranged on the second base layer 4954, 5954, or 6954 to be opposite to the first base layer 4944, 5944, or 6944, and the second cover layer 4951, 5951, or 6951 arranged on the second base layer 4954, 5954, or 6954 to cover the second metal layer 4953, 5953, or 6953. In one embodiment, the FPCB 290, 390, 590, or 690 may include, based on the extending direction, the driving area 391, 591, or 691, the first fixed area 392A, 592A, or 692A, and the second fixed area 392B, 592B, or 692B, wherein the first fixed area 392A, 592A, or 692A and the second fixed area 392B, 592B, or 692B are arranged in opposite directions to each other relative to the driving area 391, 591, or 691. In one embodiment, the thickness t1 of the first cover layer 4941, 5941, or 6941 in the driving area 391, 591, or 691 may be different from the thickness t2 or t3 of the first cover layer 4941, 5941, or 6941 in the first fixed area 392A, 592A, or 692A or the second fixed area 392B, 592B, or 692B.

In one embodiment, the first cover layer 5941 may include the first cover portion 5941a arranged in the driving area 591 and having the first thickness t1, the second cover portion 5941b arranged in the first fixed area 592A and having the second thickness t2 that is less than the first thickness t1, and the third cover portion 5941c arranged in the second fixed area 592B and having the third thickness t3 that is less than the first thickness t1.

In one embodiment, the plurality of signal lines 5946 or 6946 may extend in the extending direction and such that intervals are formed between the signal lines 5946 or 6946. In one embodiment, the interval d1 between the plurality of signal lines 5946 or 6946 in the driving area 591 or 691 may be different from the interval d3 between the plurality of signal lines 5946 or 6946 in the first fixed area 592A or 691A or in the second fixed area 592B or 692B.

In one embodiment, the plurality of signal lines 5946 may be arranged to form the first interval d1 between each other in the driving area 591. In one embodiment, the plurality of signal lines 5946 may be arranged to form the second interval d2 that is less than the first interval d1 between each other in the first fixed area 592A. In one embodiment, the plurality of signal lines 5946 may be arranged to form the third interval d3 that is less than the first interval d1 between each other in the second fixed area 592B.

According to one embodiment, the electronic device 201 or 301 may include the display 250 or 350 including the first area 250a or 350a and the second area 250b or 350b, the first housing 210 or 310 forming the first space 210a or 310a on a rear surface of the first area 250a or 350a, the second housing 220 or 320 forming the second space 220a or 320a on a rear surface of the second area 250b or 350b, the hinge structure 340 including the hinge housing 334 connecting the first housing 210 or 310 to the second housing 220 or 320 based on the folding axis A and adjusting a folding angle formed by the first housing 210 or 310 and the second housing 220 or 320, and the FPCB 290, 390, or 590 traversing the folding axis A and extending from the first space 210a or 310a to the second space 220a or 320a in the extending direction. In one embodiment, the FPCB 290, 390, or 590 may include the driving area 391 or 591 at least partially arranged in the hinge housing 334 and at least partially bending in response to a change in the folding angle, the first fixed area 392A or 592A extending from the driving area 391 or 591 to the first space 210a or 310a, the second fixed area 392B or 592B extending from the driving area 391 or 591 to the second space 220a or 320a. In one embodiment, the FPCB 290, 390, or 590 may include the first base layer 4944 or 5944 including the first base surface and the second base surface opposite to the first base surface, the first metal layer 4943 or 5943 arranged on the second base surface and forming the plurality of signal lines 5946 arranged in the extending direction, the first cover layer 4941 or 5941 arranged to cover the first metal layer 4943 or 5943 in a direction of the second base surface, the second base layer 4954 or 5954 arranged in a direction of the first base surface, the second metal layer 4953 or 5953 arranged on the second base layer 4954 or 5954 to be opposite to the first base layer 4944 or 5944, and the second cover layer 4951 or 5951 arranged on the second base layer 4954 or 5954 to cover the second metal layer 4953 or 5953. In one embodiment, the thickness t1 of the first cover layer 4911 or 5911 in the driving area 391 or 591 may be greater than the thickness t2 of the first cover layer 4911 or 5911 in the first fixed area 392A or 592A or the second fixed area 392B or 592B. In one embodiment, the interval d1 between the plurality of signal lines 5946 in the driving area 391 or 591 may be greater than the interval d2 or d3 between the plurality of signal lines 5946 in the first fixed area 392A or 592A or in the second fixed area 392B or 592B.

All of the examples, embodiments and features set out in this disclosure may be combined in any suitable manner unless described as incompatible or mutually exclusive. Furthermore, features of the various examples and embodiments may be omitted unless described as essential.

With reference to any of the above-detailed examples or embodiments it will be appreciated that the term driving area of the FPCB refers to the area that may be repeatedly driven (e.g. experiences an external driving, or bending, force) at an angle when the foldable device is open (or unfolded state) and closed (or folded state). In examples, the driving area may also be referred to as a bending area, a flexible area, or a deformable area. With reference to any of the above-detailed examples or embodiments, an extending direction may refer to an X-axis direction of the FPCB, a direction of the longitudinal length of the FPCB, that is the direction in which the FPCB extends in a direction perpendicular to the folding axis.
Further examples in accordance with the present application are set out in the following numbered paragraphs:
Paragraph 1:
   An electronic device comprising:
   a display comprising a first area and a second area;
   a first housing supporting the first area;
   a second housing supporting the second area;
   a hinge structure foldably connecting the first housing to the second housing based on a folding axis and adjusting a folding angle formed by the first housing and the second housing relative to the folding axis; and
   a flexible printed circuit board (FPCB) extending in an extending direction,
   wherein the FPCB comprises:
      a driving area traversing the folding axis and at least partially bending in response to a change in the folding angle;
      a first fixed area extending from the driving area to a first space formed by the first housing; and
      a second fixed area extending from the driving area to a second space formed by the second housing,
      wherein the FPCB comprises:
         a first base layer comprising a first base surface and a second base surface opposite to the first base surface;
         a first metal layer arranged on the second base surface and forming a plurality of signal lines extending in the extending direction; and
         a first cover layer arranged to cover the first metal layer in a direction of the second base surface,
         wherein a thickness of the first cover layer in the driving area is different from a thickness of the first cover layer in the first fixed area or the second fixed area.
Paragraph 2:
   The electronic device of paragraph 1, wherein the first cover layer comprises:
   a first cover portion arranged in the driving area and having a first thickness;
   a second cover portion arranged in the first fixed area and having a second thickness that is different from the first thickness; and
   a third cover portion arranged in the second fixed area and having a third thickness that is different from the first thickness.
Paragraph 3. The electronic device of any of paragraphs 1 and 2, wherein the first cover portion, the second cover portion, and the third cover portion are separately formed.
Paragraph 4:.
   The electronic device of any of paragraphs 1 to 3, wherein the plurality of signal lines is arranged to extend in the extending direction and such that intervals are formed between the lines, and
   an interval between the plurality of signal lines in the driving area is different from an interval between the plurality of signal lines in the first fixed area or an interval between the plurality of signal lines in the second fixed area.
Paragraph 5.
   The electronic device of any of paragraphs 1 to 4, wherein the first thickness is greater than the second thickness and the third thickness.
Paragraph 6.
   The electronic device of any of paragraph 5, wherein the plurality of signal lines:
   is arranged to form a first interval between each other in the driving area,
   is arranged to form a second interval that is less than the first interval between each other in the first fixed area, and
   is arranged to form a third interval that is less than the first interval between each other in the second fixed area.
Paragraph 7.
   The electronic device of any of paragraphs 5 to 6, wherein the first cover layer has a thickness of 20 µm to 30 µm in the driving area and has a thickness of 10 µm to 15 µm in the first fixed area and the second fixed area.
Paragraph 8
   The electronic device of paragraphs 5 to 7, wherein the plurality of signal lines form:
   an interval of about 60 µm between each signal line in the driving area, and
   an interval of about 50 µm between each signal line in the first fixed area and the second fixed area.
Paragraph 9.
   The electronic device of any of paragraphs 1 to 4, wherein the first thickness is less than the second thickness and the third thickness.
Paragraph 10.
   The electronic device of any of paragraph 9, wherein the plurality of signal lines:
   is arranged to form a first interval between each other in the driving area,
   is arranged to form a second interval that is greater than the first interval between each other in the first fixed area, and
   is arranged to form a third interval that is greater than the first interval between each other in the second fixed area.
Paragraph 11.
   The electronic device of any of paragraph 9 to 10, wherein the first cover layer has a thickness of 10 µm to 15 µm in the driving area and has a thickness of 20 µm to 30 µm in the first fixed area and the second fixed area, and
   the plurality of signal lines:
   is arranged to form an interval of 45 µm to 55 µm between each other in the driving area, and
   is arranged to form an interval of 54 µm to 66 µm between each other in the first fixed area and the second fixed area.
Paragraph 12
   The electronic device of any of paragraphs 1 to 11, wherein the hinge structure further comprises:
   a first support plate connecting the first housing to the hinge housing; and
   a second support plate connecting the second housing to the hinge housing,
   wherein the FPCB further comprises:
      a first fastening member fixed to the first support plate; and
      a second fastening member fixed to the second support plate.
Paragraph 13 The electronic device of any of paragraphs 1 to 12, wherein, based on a state in which the display is viewed, the first fastening member overlaps the driving area and the first fixed area, and
   the second fastening member overlaps the driving area and the second fixed area.
Paragraph 14.
   The electronic device of any of paragraphs 1 to 13, wherein, based on the extending direction, the driving area comprises:
   a central portion arranged in the hinge housing;
   a first bending portion extending from the central portion to the first fastening member and at least partially bending; and
   a second bending portion extending from the central portion to the second fastening member and at least partially bending,
   wherein the first fixed area comprises a first extension portion extending from the first fastening member in a direction opposite to the central portion and at least partially fixed to the first housing,
   wherein the second fixed area comprises a second extension portion extending from the second fastening member in a direction opposite to the central portion and at least partially fixed to the second housing.
Paragraph 15.
   The electronic device of any of paragraphs 1 to 14, wherein the FPCB further comprises:
   a second base layer arranged on the first base layer to be opposite to the first metal layer;
   a second metal layer arranged on the second base layer to be opposite to the first base layer; and
   a second cover layer arranged on the second base layer to cover the second metal layer.
Paragraph 16.
   The electronic device of any of paragraphs 1 to 15, wherein the FPCB is arranged such that the first base surface faces a rear surface of the display.
Paragraph 17.
   A flexible printed circuit board (FPCB) arranged in an electronic device, the FPCB comprising:
   a first base layer comprising a first base surface and a second base surface opposite to the first base surface;
   a first metal layer arranged on the second base surface and forming a plurality of signal lines arranged in an extending direction;
   a first cover layer arranged to cover the first metal layer in a direction of the second base surface;
   a second base layer arranged in a direction of the first base surface;
   a second metal layer arranged on the second base layer to be opposite to the first base layer; and
   a second cover layer arranged on the second base layer to cover the second metal layer,
   wherein the FPCB comprises, based on the extending direction, a driving area, a first fixed area, and a second fixed area, wherein the first fixed area and the second fixed area are arranged in opposite directions to each other relative to the driving area,
   wherein a thickness of the first cover layer in the driving area is different from a thickness of the first cover layer in the first fixed area or the second fixed area.
Paragraph 18.
   The FPCB of paragraph 17, wherein the first cover layer comprises:
   a first cover portion arranged in the driving area and having a first thickness;
   a second cover portion arranged in the first fixed area and having a second thickness that is less than the first thickness; and
   a third cover portion arranged in the second fixed area and having a third thickness that is less than the first thickness.
Paragraph 19.
   The FPCB of any of paragraphs 17 and 18, wherein the plurality of signal lines extends in the extending direction and such that intervals are formed between the lines, and
   an interval between the plurality of signal lines in the driving area is different from an interval between the plurality of signal lines in the first fixed area or an interval between the plurality of signal lines in the second fixed area.
Paragraph 20.
   The FPCB of any of paragraphs 17 to 19, wherein the plurality of signal lines:
   is arranged to form a first interval between each other in the driving area,
   is arranged to form a second interval that is less than the first interval between each other in the first fixed area, and
   is arranged to form a third interval that is less than the first interval between each other in the second fixed area.
Paragraph 21.
   An electronic device comprising:
   a display comprising a first area and a second area;
   a first housing forming a first space on a rear surface of the first area;
   a second housing forming a second space on a rear surface of the second area;
   a hinge structure comprising a hinge housing connecting the first housing to the second housing based on the folding axis and adjusting a folding angle formed by the first housing and the second housing; and
   a flexible printed circuit board (FPCB) traversing the folding axis and extending from the first space to the second space in the extending direction,
   wherein the FPCB comprises:
      a driving area at least partially arranged in the hinge housing and at least partially bending in response to a change in the folding angle;
      a first fixed area extending from the driving area to the first space;
      a second fixed area extending from the driving area to the second space;
      a first base layer comprising a first base surface and a second base surface opposite to the first base surface;
      a first metal layer arranged on the second base surface and forming a plurality of signal lines arranged in an extending direction;
      a first cover layer arranged to cover the first metal layer in a direction of the second base surface;
      a second base layer arranged in a direction of the first base surface;
      a second metal layer arranged on the second base layer to be opposite to the first base layer; and
      a second cover layer arranged on the second base layer to cover the second metal layer,
      wherein a thickness of the first cover layer in the driving area is greater than a thickness of the first cover layer in the first fixed area or the second fixed area,
      wherein an interval between the plurality of signal lines in the driving area is greater than an interval between the plurality of signal lines in the first fixed area or an interval between the plurality of signal lines in the second fixed area.
Paragraph 22
   A flexible printed circuit board (FPCB) comprising:
   a first base layer comprising a first base surface and a second base surface opposite to the first base surface;
   a first metal layer arranged on the second base surface and forming a plurality of signal lines arranged in an extending direction along a longitudinal length of the FPCB; and
   a first cover layer arranged to cover the first metal layer in a direction of the second base surface;
   wherein the FPCB comprises, based on the extending direction, a driving area, a first fixed area, and a second fixed area, wherein the first fixed area and the second fixed area are arranged on opposite sides of the driving area,
   wherein a thickness of the first cover layer in the driving area is different from a thickness of the first cover layer in the first fixed area or the second fixed area.
Paragraph 23.
   The FPCB of paragraph 22, wherein the formed plurality of signal lines are arranged to extend in the extending direction and wherein intervals are formed between each of the signal lines of the plurality of signal lines, and
   wherein an interval between each of the plurality of signal lines in the driving area is different from an interval between each of the plurality of signal lines in the first fixed area or an interval between each of the plurality of signal lines in the second fixed area.
Paragraph 24.
   The FPCB of paragraphs 22 or 23, wherein the first cover layer comprises:
   a first cover portion arranged in the driving area and having a first thickness;
   a second cover portion arranged in the first fixed area and having a second thickness that is different to the first thickness; and
   a third cover portion arranged in the second fixed area and having a third thickness that is different to the first thickness.
Paragraph 25.
   The FPCB of paragraph 24, wherein the first cover portion, the second cover portion, and the third cover portion are separately formed.
Paragraph 26.
   The FPCB of paragraph 24 or paragraph 25, wherein the first thickness is greater than the second thickness and the third thickness.
Paragraph 27.
   The FPCB of any of paragraphs 24 to 26, wherein the plurality of signal lines:
   is arranged to form a first interval between each other in the driving area,
   is arranged to form a second interval that is less than the first interval between each other in the first fixed area, and
   is arranged to form a third interval that is less than the first interval between each other in the second fixed area.
Paragraph 28.
   The FPCB of any of paragraphs 24 to 27, wherein the first cover layer has a thickness of 20 µm to 30 µm in the driving area and has a thickness of 10 µm to 15 µm in the first fixed area and the second fixed area.
Paragraph 29.
   The FPCB of paragraphs 24-28, wherein the plurality of signal lines form:
   an interval of about 60 µm between each signal line in the driving area, and
   an interval of about 50 µm between each signal line in the first fixed area and the second fixed area.
Paragraph 30.
   The FPCB of any of paragraphs 24 to 25, wherein the first thickness is less than the second thickness and the third thickness; and
   wherein the plurality of signal lines:
   is arranged to form a first interval between each other in the driving area,
   is arranged to form a second interval that is greater than the first interval between each other in the first fixed area, and
   is arranged to form a third interval that is greater than the first interval between each other in the second fixed area.
Paragraph 31.
   The FPCB of any of paragraph 30, wherein the first cover layer has a thickness of 10 µm to 15 µm in the driving area and has a thickness of 20 µm to 30 µm in the first fixed area and the second fixed area, and
   the plurality of signal lines:
   is arranged to form an interval of 45 µm to 55 µm between each other in the driving area, and
   is arranged to form an interval of 54 µm to 66 µm between each other in the first fixed area and the second fixed area.
Paragraph 32.
   The FPCB of any of paragraphs 22-31, wherein the FPCB further comprises:
   a second base layer arranged on the first base layer to be opposite to the first metal layer;
   a second metal layer arranged on the second base layer to be opposite to the first base layer; and
   a second cover layer arranged on the second base layer to cover the second metal layer.
Paragraph 33.
   An electronic device comprising
   a display comprising a first area and a second area;
   a first housing supporting the first area;
   a second housing supporting the second area;
   a hinge structure arranged to connect the first housing to the second housing based on a folding axis and to adjust a folding angle formed by the first housing and the second housing relative to the folding axis; and
   the FPCB according to any one of paragraphs 22-32, the FPCB extending across the folding axis in the extending direction from a first space formed in the first housing to a second space formed in the second housing, wherein:
      the driving area of the FPCB traverses the folding axis and is arranged to at least partially bend in response to a change in the folding angle; and
      the first fixed area extends from the driving area to the first space; and
      the second fixed area extends from the driving area to the second space.
Paragraph 34.
   The electronic device of paragraph 33, the hinge structure comprising a hinge housing connecting the first housing to the second housing based on the folding axis, wherein hinge structure further comprises:
   a first support plate connecting the first housing to the hinge housing; and
   a second support plate connecting the second housing to the hinge housing,
   wherein the FPCB further comprises:
      a first fastening member fixed to the first support plate; and
      a second fastening member fixed to the second support plate.
Paragraph 35.
   The electronic device of paragraph 34, wherein, when the display is viewed from above, the first fastening member overlaps the driving area and the first fixed area, and the second fastening member overlaps the driving area and the second fixed area.
Paragraph 36.
   The electronic device of any of paragraphs 34-35, wherein, based on the extending direction, the driving area comprises:
   a central portion arranged in the hinge housing;
   a first bending portion extending from the central portion to the first fastening member and at least partially bending; and
   a second bending portion extending from the central portion to the second fastening member and at least partially bending,
   wherein the first fixed area comprises a first extension portion extending from the first fastening member in a direction opposite to the central portion and at least partially fixed to the first housing,
   wherein the second fixed area comprises a second extension portion extending from the second fastening member in a direction opposite to the central portion and at least partially fixed to the second housing.
Paragraph 37.
   An electronic device 101, 201, or 301 comprising:
   a display 250 or 350 comprising a first area 250a or 350a and a second area 250b or 350b;
   a first housing 210 or 310 supporting the first area 250a or 350a;
   a second housing 220 or 320 supporting the second area 250b or 350b;
   a hinge structure 340 foldably connecting the first housing 210 or 310 to the second housing 220 or 320 based on a folding axis A and adjusting a folding angle formed by the first housing 210 or 310 and the second housing 220 or 320 relative to the folding axis A; and
   a flexible printed circuit board (FPCB) 290, 390, 590, or 690 extending in an extending direction,
   wherein the FPCB 290, 390, 590, or 690 comprises:
      a driving area 391, 591, or 691 traversing the folding axis and at least partially bending in response to a change in the folding angle;
      a first fixed area 392A, 592A, or 692A extending from the driving area 391, 591, or 691 to a first space 210a or 310a formed by the first housing 210 or 310; and
      a second fixed area 392B, 592B, or 692B extending from the driving area 391, 591, or 691 to a second space 220a or 320a formed by the second housing 220 or 320,
      wherein the FPCB 290, 390, 590, or 690 comprises:
         a first base layer 4944, 5944, or 6944 comprising a first base surface and a second base surface opposite to the first base surface;
         a first metal layer 4943, 5943, or 6943 arranged on the second base surface and forming a plurality of signal lines 4946 extending in the extending direction; and
         a first cover layer 4941, 5941, or 6941 arranged to cover the first metal layer 4943, 5943, or 6943 in a direction of the second base surface,
   wherein a thickness t1 of the first cover layer 4941, 5941, or 6941 in the driving area 391, 591, or 691 is different from a thickness t2, or t3 of the first cover layer 4941 in the first fixed area 392A, 592A, or 692A or the second fixed area 392B, 592B, or 692B.
Paragraph 38.
   The electronic device of Paragraph 37, wherein the first cover layer 4941, 5941, or 6941 comprises:
   a first cover portion 4941a, 5941, or 6941a arranged in the driving area 491, 591, or 691 and having a first thickness t1;
   a second cover portion 4941b, 5941b, or 6941b arranged in the first fixed area 492A, 592A, or 692A and having a second thickness t2 that is different from the first thickness t1; and
   a third cover portion 4941c, 5941c, or 6941c arranged in the second fixed area 492B, 592B, 692B and having a third thickness t3 that is different from the first thickness t1.
Paragraph 39.
   The electronic device of any of Paragraphs 37 or 38, wherein the first cover portion 4941a, 5941, or 6941a, the second cover portion 4941b, 5941b, or 6941b, and the third cover portion 4941c, 5941c, or 6941c are separately formed.
Paragraph 40.
   The electronic device of any of Paragraphs 37 to 39, wherein the plurality of signal lines 5846 or 6946 is arranged to extend in the extending direction and such that intervals are formed between the lines, and
   an interval d1 between the plurality of signal lines 5946 or 6946 in the driving area 491, 591, or 691 is different from an interval d2 between the plurality of signal lines 5946 or 6946 in the first fixed area 492A, 592A, or 692A or an interval d3 between the plurality of signal lines 5946 or 6946 in the second fixed area 492B, 592B, or 692B.
Paragraph 41.
   The electronic device of any of Paragraphs 37 to 40, wherein the first thickness t1 is greater than the second thickness t2 and the third thickness t3.
Paragraph 42.
   The electronic device of Paragraph 41, wherein the plurality of signal lines 5946:
   is arranged to form a first interval d1 between each other in the driving area 591,
   is arranged to form a second interval d2 that is less than the first interval d1 between each other in the first fixed area 592A, and
   is arranged to form a third interval d3 that is less than the first interval d1 between each other in the second fixed area 592B.
Paragraph 43.
   The electronic device of any of Paragraphs 41 to 42, wherein the first cover layer 5941 has a thickness of 20 µm to 30 µm in the driving area 591 and has a thickness of 10 µm to 15 µm in the first fixed 592A area and the second fixed area 592, and
   wherein the plurality of signal lines 5946 form:
   an interval of about 60 µm between each signal line in the driving area 591, and
   an interval of about 50 µm between each signal line in the first fixed area 592A and the second fixed area 592B
Paragraph 44.
   The electronic device of any of Paragraphs 37 to 40, wherein the first thickness t1 is less than the second thickness t2 and the third thickness t3.
Paragraph 45.
   The electronic device of claim 44, wherein the plurality of signal lines 6946:
   is arranged to form a first interval d1 between each other in the driving area 691,
   is arranged to form a second interval d2 that is greater than the first interval d1 between each other in the first fixed area 692A, and
   is arranged to form a third interval d3 that is greater than the first interval d1 between each other in the second fixed area 692B.
Paragraph 46.
   The electronic device of any of Paragraphs 37 to 45, wherein the first cover layer 6941 has a thickness of 10 µm to 15 µm in the driving area 691 and has a thickness of 20 µm to 30 µm in the first fixed area 692A and the second fixed area 692B, and
   the plurality of signal lines 6946:
   is arranged to form an interval of 45 µm to 55 µm between each other in the driving area, and
   is arranged to form an interval of 55 µm to 65 µm between each other in the first fixed area and the second fixed area.
Paragraph 47.
   The electronic device of any of Paragraphs 37 to 46, wherein the hinge structure 340 further comprises:
   a first support plate 331 connecting the first housing 310 to a hinge housing 346; and
   a second support plate 332 connecting the second housing 320 to the hinge housing 346,
   wherein the FPCB 290, 390, 590, or 690 further comprises:
      a first fastening member 3931, 5931, or 6931 fixed to the first support plate 331; and
      a second fastening member 3932, 5932, or 6932 fixed to the second support plate 332.
Paragraph 48.
   The electronic device of any of Paragraphs 37 to 47, wherein, when the display 350 is viewed from above, the first fastening member 3931, 5931, or 6931 overlaps the driving area 391, 591, or 691 and the first fixed area 392A, 592A, or 692A, and
   the second fastening member 3932, 5932, or 6932 overlaps the driving area 391, 591, 691 and the second fixed area 392B, 592B, or 692B.
Paragraph 49.
   The electronic device of any of Paragraphs 37 to 48, wherein, based on the extending direction, the driving area 391, 591, or 691 comprises:
   a central portion 3911, 5911, or 6911 arranged in the hinge housing 334;
   a first bending portion 3912a, 5912a, or 6912a extending from the central portion 3911, 5911, or 6911 to the first fastening member 3931, 5931, or 6931 and at least partially bending; and
   a second bending portion 3912b, 5912b, 6912b extending from the central portion 3911, 5911, 6911 to the second fastening member 3932, 5932, or 6932 and at least partially bending,
   wherein the first fixed area 392A, 592A, or 692A comprises a first extension portion 3921, 5921, or 6921 extending from the first fastening member 3931, 5931, or 6931 in a direction opposite to the central portion 3911, 5911, or 6911 and at least partially fixed to the first housing 210 or 310,
   wherein the second fixed area 392B, 592B, or 692B comprises a second extension portion 3922, 5922, or 6922 extending from the second fastening member 3932, 5932, or 6932 in a direction opposite to the central portion 3911, 5911, or 6911 and at least partially fixed to the second housing 220 or 320.
Paragraph 50.
   The electronic device of any of Paragraphs 37 to 49, wherein the FPCB 390, 590, or 690 further comprises:
   a second base layer 4954, 5954, or 6954 arranged on the first base layer 4944, 5944, or 6944 to be opposite to the first metal layer 4943, 5943, or 6943;
   a second metal layer 4953, 5953, or 6953 arranged on the second base layer 4954, 5954, or 6954 to be opposite to the first base layer 4944, 5944, or 6944; and
   a second cover layer 4951, 5951, or 6951 arranged on the second base layer 4954, 5954, or 6954 to cover the second metal layer 4953, 5953, or 6953.
Paragraph 51.
   The electronic device of any of Paragraphs 37 to 50, wherein the FPCB 390, 590, or 690 is arranged such that the first base surface faces a rear surface of the display 250 or 350.

## Claims

1. A foldable electronic device (101, 201, or 301) comprising:
a housing including a first housing (210 or 310) and a second housing foldable and unfoldable with respect to each other;
a display (250 or 350) including a first displaying area (250a or 350a) and a second displaying area (250b or 350b) accommodated in the first housing and the second housing, respectively;
a hinge structure (340) foldably connected with each of the first housing (210 or 310) and the second housing (220 or 320); and
a flexible printed circuit board, FPCB (290, 390, 590, or 690) disposed across the hinge structure (230, 340); and
wherein, when viewed from above, the FPCB includes:
a driving area (391, 591, or 691) disposed as overlapped with the hinge structure (230);
a first fixed area (392A, 592A, or 692A) extended from the driving area as accommodated in the first housing; and
a second fixed area (392B, 592B, or 692B) extended from the driving area as accommodated in the second housing;
wherein, when viewed from a side, the FPCB includes a first layer part (494) and a second layer part disposed over each other, the first layer part including:
a first base layer (4944, 5944, or 6944) including a first base surface and a second base surface opposite to each other;
a first metal layer (4943, 5943, or 6943) disposed on the second base surface and including a plurality of signal lines (4946) arranged such that an interval is formed between each pair of the plurality of signal lines; and
a first cover layer (4941, 5941, or 6941) disposed on the first metal layer (4943, 5943, or 6943); and
wherein a first thickness of the first cover layer (4941, 5941, or 6941) in the driving area (391, 591, or 691) is different from a second thickness of the first cover layer (4941) in the first fixed area (392A, 592A, or 692A) or the second fixed area (392B, 592B, or 692B), and a first interval between a pair of the plurality of signal lines (5946 or 6946) in the driving area (491, 591, or 691) is different from a second interval between the pair of the plurality of signal lines (5946 or 6946) in the first fixed area (492A, 592A, or 692A) or a third interval between the pair of the plurality of signal lines (5946 or 6946) in the second fixed area.

2. The foldable electronic device of claim 1,
wherein the hinge structure (340) includes a hinge housing (334), and wherein the first layer part of the FPCB faces the hinge housing such that the first base layer faces a rear surface of the display and the first cover layer (4941, 5941, 6941) faces the hinge housing.

3. The foldable electronic device of claim 1,
wherein the first cover layer (5941) includes a first cover portion (5941a), a second cover portion (5941b) and a third cover portion (5941c) corresponding to the driving area (591), the first fixed area (592A) and the second fixed area (592B), respectively, and
wherein the FPCB includes a first fastening member (5931) disposed in a boundary area between the first cover portion (5941a) and the second cover portion (5941b), and a second fastening member (5932) disposed in a boundary area between the first cover portion (5941a) and the third cover portion (5941c).

4. The foldable electronic device of claim 1, wherein the hinge structure (340) includes a hinge housing (334), further comprising:
a first support plate (331) accommodated in the first housing (210 or 310) as supporting the first displaying area; and
a second support plate (332) accommodated in the second housing (220 or 320) as supporting the second displaying area; and
wherein a portion (3911) of the driving area of the FPCB is disposed in the hinge housing as bent therein, a first ending portion (3912a) of the driving area is extended toward the first support plate (331), and a second ending portion (3912b) of the driving area is extended toward the second support plate (332).

5. The foldable electronic device of claim 4,
wherein the first cover layer (5941) includes a first cover portion (5941a), a second cover portion (5941b) and a third cover portion (5941c) corresponding to the driving area (591), the first fixed area (592A) and the second fixed area (592B), respectively, wherein a first fastening member disposed in a boundary area between the first cover portion (5941a) and the second cover portion (5941b) is attached to the first support plate (331).

6. The foldable electronic device of claim 5,
wherein a second fastening member disposed in a boundary area between the first cover portion (5941a) and the third cover portion (5941c) is attached to the second support plate (332).

7. The foldable electronic device of claim 5, wherein the first support plate includes a first opening (331a) formed therein and the second support plate includes a second opening (332a) formed therein, and
wherein the first fixed area (392A, 592A, or 692A) is extended from the first ending portion (3912 a) under the first support plate through the first opening (331 a), and the second fixed area (392B, 592B, or 692B) is extended from the second ending portion (3912b) under the second support plate through the second opening (332a).

8. The foldable electronic device of claim 7,
wherein a portion of the first fixed area is fixed to the first support plate (331), and a portion of the second fixed area is fixed to the second support plate (332).

9. The foldable electronic device of claim 2, wherein the second layer part (495) is disposed over the first layer part as facing the rear surface of the display.
